(19) Europäisches Patentamt
European Patent Office
Office européen des brevets

(11) **EP 4 394 892 B1**

(12) **EUROPEAN PATENT SPECIFICATION**

(45) Date of publication and mention
of the grant of the patent:
**30.07.2025 Bulletin 2025/31**

(51) International Patent Classification (IPC):
**H10D 30/67** (2025.01)    **H10D 86/40** (2025.01)
**H10D 86/60** (2025.01)

(21) Application number: **23196115.2**

(52) Cooperative Patent Classification (CPC):
**H10D 30/6755; H10D 30/6757;** H10D 30/6723;
H10D 86/423; H10D 86/481; H10D 86/60;
H10D 99/00

(22) Date of filing: **07.09.2023**

(54) **THIN FILM TRANSISTOR AND DISPLAY APPARATUS COMPRISING THE SAME**

DÜNNSCHICHTTRANSISTOR UND ANZEIGEVORRICHTUNG DAMIT

TRANSISTOR À COUCHES MINCES ET APPAREIL D'AFFICHAGE LE COMPRENANT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **26.12.2022 KR 20220184668**

(43) Date of publication of application:
**03.07.2024 Bulletin 2024/27**

(73) Proprietor: **LG Display Co., Ltd.
Seoul 07336 (KR)**

(72) Inventors:
• **CHOI, Sungju
10845 Paju-si, Gyeonggi-do (KR)**
• **SEUL, Hyeonjoo
10845 Paju-si, Gyeonggi-do (KR)**
• **JUNG, Jinwon
10845 Paju-si, Gyeonggi-do (KR)**
• **PARK, Jaeyoon
10845 Paju-si, Gyeonggi-do (KR)**

(74) Representative: **Bryn-Jacobsen, Caelia
Kilburn & Strode LLP
Lacon London
84 Theobalds Road
London WC1X 8NL (GB)**

(56) References cited:
**CN-A- 114 628 528    KR-A- 20230 067 042**

## Description

## BACKGROUND OF THE DISCLOSURE

### Field of the Invention

The present disclosure relates to a thin film transistor and a display apparatus comprising the same.

### Discussion of the Related Art

Transistors are widely used as switching devices or driving devices in the field of electronic apparatuses. In particular, because a thin film transistor can be manufactured on a glass substrate or a plastic substrate, the thin film transistor is widely used as a switching device of a display apparatus such as a liquid crystal display apparatus or an organic light emitting apparatus.

The display apparatus may include, for example, a switching thin film transistor and a driving thin film transistor. Generally, it is preferable that the driving thin film transistor has a large s-factor (or sub-threshold swing) to represent a gray scale. However, the thin film transistors generally have a small s-factor to ensure on-off characteristics. Thus, when thin film transistors are applied to the driving thin film transistor of the display apparatus, it is difficult to represent a gray scale of the display apparatus.

Therefore, the thin film transistor applied to the driving thin film transistor of the display apparatus also needs to have a large s-factor to easily represent a gray scale. Also, even though the thin film transistor has a large s-factor, the thin film transistor should have excellent current characteristics in an ON-state.

KR20230067042A in a machine translation of an abstract states that "An embodiment of the present invention includes a first gate electrode and a second gate electrode that are spaced apart from each other and overlap, and a first active layer and a second active layer disposed between the first gate electrode and the second gate electrode. and an active layer wherein the active layer includes a channel portion, a first connection portion in contact with one side of the channel portion, and a second connection portion in contact with the other side of the channel portion, and the channel portion includes a first channel portion disposed in parallel. and a second channel portion, wherein the first channel portion and the second channel portion extend from the first connection portion to the second connection portion, respectively, and the first channel portion includes the first gate electrode and the second gate electrode. Overlapping, the second channel portion does not overlap the first gate electrode but overlaps the second gate electrode, and the first active layer is a thin film transistor made of a material having a lower mobility than the second active layer, and such a display device including a thin film transistor is provided."

CN114628528A in an abstract states that "One embodiment of the present disclosure provides a thin film transistor including an auxiliary electrode, a gate electrode, and an active layer disposed between the auxiliary electrode and the gate electrode, the active layer includes a channel portion overlapping with the gate electrode, a first connection portion disposed on one side of the channel portion, and a second connection portion disposed on the other side of the channel portion, and the channel portion includes a portion overlapping with the auxiliary electrode and a portion not overlapping with the auxiliary electrode. One embodiment of the present disclosure also provides a display device including the thin film transistor."

## SUMMARY OF THE DISCLOSURE

The present invention is set out in the independent claims, with some optional features set out in the claims dependent thereto.

The present disclosure has been made in view of the above problems and it is an object of the present disclosure to provide a thin film transistor that has a large s-factor and has excellent current characteristics in an ON-state.

It is another object of the present disclosure to provide a thin film transistor having a large current value in an ON-state while having a large s-factor by partially stacking two different types of oxide semiconductor layers to form a two-channel structure.

It is still another object of the present disclosure to provide a thin film transistor designed such that an interval between a gate electrode and an active layer is not greater than necessary to have excellent ON-current characteristics as the interval between the gate electrode and the active layer does not need to be increased to increase an s-factor of the thin film transistor.

It is further still another object of the present disclosure to provide a display apparatus including a driving thin film transistor having a large s-factor and large ON-current characteristics to have an excellent gray scale representation capability and excellent current characteristics.

In addition to the objects of the present disclosure as mentioned above, additional objects and features of the present disclosure will be clearly understood by those skilled in the art from the following description of the present disclosure.

In accordance with an aspect of the present disclosure, the above and other objects are accomplished by including a thin film transistor having an active layer, and a gate electrode at least partially overlapped with the active layer. Further, the active layer includes a channel portion (e.g. a channel), a first connection portion contacting one side of the channel portion, and a second connection portion contacting the other side of the channel portion, the active layer includes a first active layer and a second active layer on the first active layer, the channel portion includes a first overlap area in which the first active layer and the second active layer overlap each other based on a plan view (from above), and a first non-overlap area in which the first active layer and the second active layer do not overlap each other based on the plan view. Also, each of the first active layer and the second active layer extends from the first connection portion to the second connection portion in the channel portion. In this instance, the second active layer can have a mobility greater (electron mobility) than a mobility of the first active layer.

In addition, the first overlap area can extend from the first connection portion to the second connection portion, and first non-overlap area can extend from the first connection portion to the second connection portion. The second active layer can cover an entire upper surface of the first active layer in the channel portion, and the second active layer can be disposed in an entire area of the channel portion based on the plan view. Also, the first active layer is not disposed in the first non-overlap area.

The active layer may further include a third active layer on the second active layer, and the third active layer can extend from the first connection portion to the second connection portion in the channel portion. The third active layer can also have a mobility smaller than a mobility of the second active layer. Also, the third active layer can be disposed in the first overlap area and the first non-overlap area. However, the third active layer may not be disposed in the first non-overlap area.

In addition, the channel portion can further include a second non-overlap area in which the first active layer and the second active layer do not overlap each other based on the plan view, and the second non-overlap area can be spaced apart from the first non-overlap area and may extend from the first connection portion to the second connection portion. The first active layer may not be disposed in the second non-overlap area.

Further, the active layer can further include a third active layer on the second active layer, and the third active layer can extend from the first connection portion to the second connection portion in the channel portion. The third active layer can also have a mobility smaller than a mobility of the second active layer, and be disposed in the first overlap area, the first non-overlap area and the second non-overlap area. Also, the third active layer may not be disposed in the second non-overlap area.

In addition, the channel portion can further include a second overlap area in which the first active layer and the second active layer overlap each other based on the plan view, and the second overlap area can be spaced apart from the first overlap area, and thus can extend from the first connection portion to the second connection portion.

The active layer can further include a third active layer on the second active layer, and the third active layer can extend from the first connection portion to the second connection portion in the channel portion. The third active layer can also have a mobility smaller than a mobility of the second active layer, and be disposed in the first overlap area, the first non-overlap area and the second overlap area. However, the third active layer may not be disposed in the first non-overlap area.

In addition, the first active layer can include at least one of an IGZO(InGaZnO)-based oxide semiconductor material, a GZO(GaZnO)-based oxide semiconductor material, an IGO(InGaO)-based oxide semiconductor material, or a GZTO(GaZnSnO)-based oxide semiconductor material, and when the oxide semiconductor material of the first active layer includes gallium (Ga) and indium (In), a concentration of gallium (Ga) may be higher than a concentration of indium (In) based on the number of moles [Ga concentration > In concentration].

The second active layer may include at least one of an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based semiconductor material, a ZnO-based oxide semiconductor material, a SIZO(SiInZnO)-based oxide semiconductor material, or a ZnON(Zn-Oxynitride)-based oxide semiconductor material, and when the oxide semiconductor material of the second active layer includes gallium (Ga) and indium (In), a concentration of indium (In) may be higher than a concentration of gallium (Ga) based on the number of moles [Ga concentration < In concentration].

In accordance with another aspect of the present disclosure, the above and other objects can be accomplished by the provision of a display apparatus comprising the above-described thin film transistor.

## BRIEF DESCRIPTION OF THE DRAWINGS

The above and other objects, features and advantages of the present disclosure will be more clearly understood from the following detailed description taken in conjunction with the accompanying drawings, in which:

　FIG. 1A is a plan view illustrating a thin film transistor according to one example of the present disclosure, FIG. 1B is a cross-sectional view taken along line I-I' of FIG. 1A, FIG. 1C is a cross-sectional view taken along line II-II' of FIG. 1A, and FIG. 1D is a cross-sectional view taken along line III-III' of FIG. 1A;

　FIG. 2 is a cross-sectional view illustrating a thin film transistor according to another example of the present disclosure;

　FIG. 3A is a plan view illustrating a thin film transistor according to still another example of the present disclosure, and 3B is a cross-sectional view taken along line Ia-Ia' of FIG. 3A;

　FIG. 4A is a plan view illustrating a thin film transistor 400 according to still another example of the present disclosure, and FIG. 4B is a cross-sectional view taken along line Ib-Ib' of FIG. 4A;

FIG. 5A is a plan view illustrating a thin film transistor according to still another example of the present disclosure, and 5B is a cross-sectional view taken along line IV-IV' of FIG. 5A;

FIG. 6 is a cross-sectional view illustrating a thin film transistor according to further still another example of the present disclosure;

FIG. 7A is a plan view illustrating a thin film transistor 700 according to further still another example of the present disclosure, and FIG. 7B is a cross-sectional view taken along line IVa-IVa' of FIG. 7A;

FIG. 8A is a plan view illustrating a thin film transistor according to further still another example of the present disclosure, and 8B is a cross-sectional view taken along line V-V' of FIG. 8A;

FIG. 9A is a plan view illustrating a thin film transistor 900 according to further still another example of the present disclosure, and FIG. 9B is a cross-sectional view taken along line Va-Va' of FIG. 9A;

FIG. 10A is a plan view illustrating a thin film transistor 1000 according to further still another example of the present disclosure, and FIG. 10B is a cross-sectional view taken along the line Vb-Vb' of FIG. 10A;

FIGS. 11A and 11B are schematic views illustrating a gate voltage applied to a thin film transistor;

FIGS. 12A and 12B are schematic views illustrating a gate voltage applied to a thin film transistor;

FIG. 13A is a graph illustrating a relation between an s-factor and an ON-current, and FIG. 13B is a graph illustrating threshold voltages of thin film transistors;

FIG. 14 is a schematic view illustrating a display apparatus according to another example of the present disclosure;

FIG. 15 is a circuit view illustrating any one pixel of FIG. 14;

FIG. 16 is a plan view illustrating the pixel of FIG. 14;

FIG. 17 is a cross-sectional view taken along line VI-VI' of FIG. 16;

FIG. 18 is a circuit view illustrating any one pixel of a display apparatus according to still another example of the present disclosure; and

FIG. 19 is a circuit view illustrating any one pixel of a display apparatus according to further still another example of the present disclosure.

## DETAILED DESCRIPTION OF THE DISCLOSURE

Advantages and features of the present disclosure, and implementation methods thereof will be clarified through following examples described with reference to the accompanying drawings. The present disclosure may, however, be embodied in different forms and should not be construed as limited to the examples set forth herein. Rather, these examples are provided so that this disclosure will be thorough and complete, and will fully explain the present disclosure to those skilled in the art.

A shape, a size, a ratio, an angle, and a number disclosed in the drawings for describing examples of the present disclosure are merely an example, and thus, the present disclosure is not limited to the illustrated details. Like reference numerals refer to like elements throughout the specification.

When 'comprise', 'have', and 'include' described in the present specification are used, another part may be added unless 'only~' is used. The terms of a singular form may include plural forms unless referred to the contrary. In construing an element, the element is construed as including an error range although there is no explicit description. In describing a position relationship, for example, when the position relationship is described as 'upon~', 'above~', 'below~', and 'next to~', one or more portions may be arranged between two other portions unless 'just' or 'direct' is used.

Spatially relative terms such as "below", "beneath", "lower", "above", and "upper" may be used herein to easily describe a relationship of one element or elements to another element or elements as illustrated in the figures. These terms are intended to encompass different orientations of the device in addition to the orientation depicted in the figures. For example, if the device illustrated in the figure is reversed, the device described to be arranged "below," or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after," "subsequent," "next," and "before," a case which is not continuous may be included, unless "just" or "direct" is used. Although the terms "first", "second ," etc. may be used herein to describe various elements, these elements should not be limited by these terms. These terms are only used to partition one element from another. For example, a first element could be termed a second element, and, similarly, a second element could be termed a first element, without departing from the scope of the present invention.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various examples of the present disclosure can be partially or overall coupled to or combined with each other, and be variously inter-operated with each other and driven technically as those skilled in the art can sufficiently understand. The examples of the present disclosure can be performed independently from each other, or be performed together in a co-dependent relationship.

In the drawings, the same or similar elements are denoted by the same reference numerals even though they are depicted in different drawings. In the examples of the present disclosure, a source electrode and a drain electrode are distinguished from each other, for convenience of description. However, the source electrode and the drain electrode may be used interchangeably. Further, the source electrode can be the drain electrode, and the drain electrode can be the source electrode. Also, the source electrode in any one example of the present disclosure can be the drain electrode in another example of the present disclosure, and the drain electrode in any one example of the present disclosure can be the source electrode in another example of the present disclosure.

In some examples of the present disclosure, for convenience of description, a source region is distinguished from a source electrode, and a drain region is distinguished from a drain electrode. However, the examples of the present disclosure are not limited to this structure. For example, a source region can be a source electrode, and a drain region can be a drain electrode. Also, a source region can be a drain electrode, and a drain region can be a source electrode. In addition, in some examples of the present disclosure, the term "channel" may mean "channel portion", and the term "channel portion" may mean "channel".

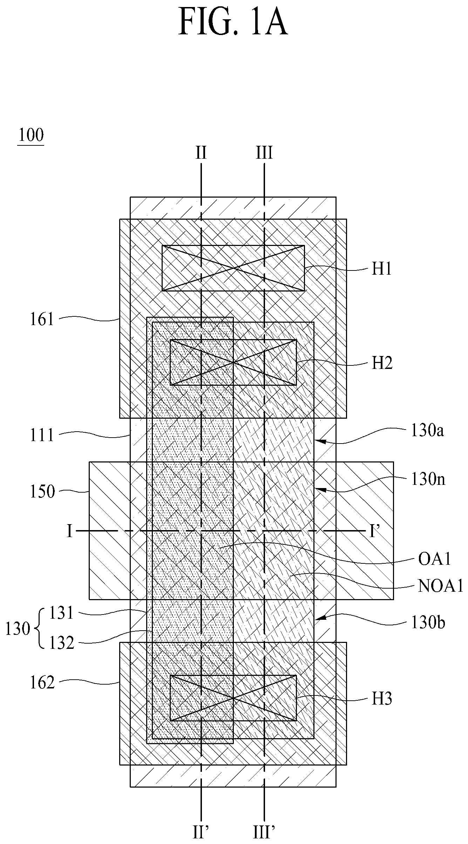

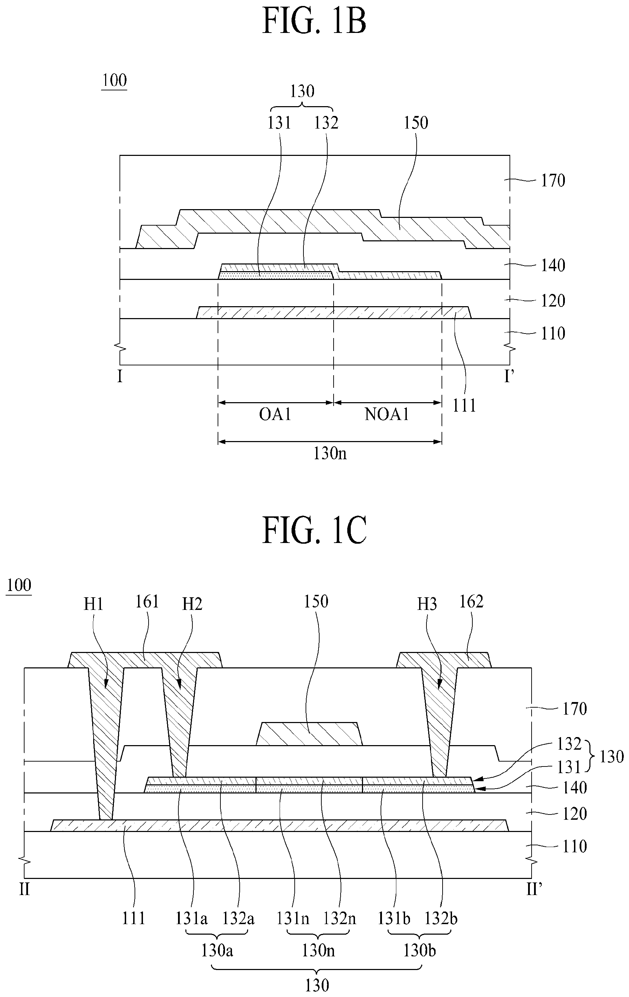

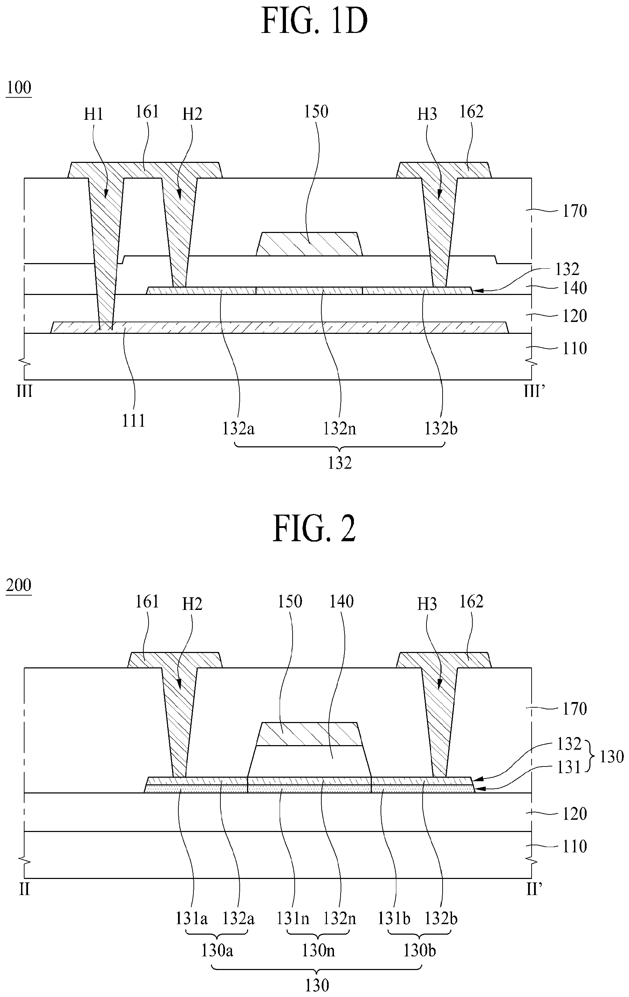

Next, FIG. 1A is a plan view illustrating a thin film transistor according to one example of the present disclosure, FIG. 1B is a cross-sectional view taken along line I-I' of FIG. 1A, FIG. 1C is a cross-sectional view taken along line II-II' of FIG. 1A, and FIG. 1D is a cross-sectional view taken along line III-III' of FIG. 1A.

As shown, a thin film transistor 100 according to one example of the present disclosure includes an active layer 130 and a gate electrode 150 that at least partially overlaps the active layer 130. The active layer 130 includes a channel portion 130n, a first connection portion 130a contacting one side of the channel portion 130n, and a second connection portion 130b contacting the other side of the channel portion 130n. Also, the active layer 130 includes a first active layer 131 and a second active layer 132 on the first active layer 131. In the examples of the present disclosure, the channel portion can be referred to as "channel", and the channel portion 130n may be referred to as "channel 130n".

In addition, as shown in FIG. 1B, the channel portion 130n includes a first overlap area OA1 in which the first active layer 131 and the second active layer 132 overlap each other based on the plan view, and a first non-overlap area NOA1 in which the first active layer 131 and the second active layer 132 do not overlap each other based on the plan view. In the channel portion 130n, each of the first active layer 131 and the second active layer 132 is extended from the first connection portion 130a to the second connection portion 130b.

Hereinafter, the thin film transistor 100 according to one example of the present disclosure will be described in more detail with reference to FIGS. 1A to 1D. Referring to FIGS. 1A to 1D, the thin film transistor 100 is disposed on a substrate 110. Glass or plastic can be used as the substrate 110. A transparent plastic having a flexible property, for example, polyimide can be used as the plastic. When polyimide is used as the substrate 110, a heat-resistant polyimide capable of enduring a high temperature can be used considering that a high temperature deposition process is performed on the substrate 110.

Also, a light shielding layer 111 can be disposed on the substrate 110. The light shielding layer 111 has light shielding characteristics to shield light incident from the outside, thereby protecting the channel portion 130n. The light shielding layer 111 can be disposed to overlap at least the channel portion 130n of the active layer 130.

Further, the light shielding layer 111 can include a metal, and have electrical conductivity. For example, the light shielding layer 111 may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), titanium (Ti), or iron (Fe). The light shielding layer 111 can also have a multi-layered structure that includes at least two conductive layers having different respective physical properties.

A buffer layer 120 is also disposed on the substrate 110 and the light shielding layer 111. The buffer layer 120 can include at least one selected from silicon oxide, silicon nitride or metal-based oxide as an insulating material. The buffer layer 120 can also have a single-layered structure or a multi-layered structure.

Further, the buffer layer 120 planarizes an upper portion of the substrate 110. In addition, the buffer layer 120 can have air and moisture barrier properties and insulating properties to protect the thin film transistor 100. The buffer layer 120 also allows the light shielding layer 111 and the channel portion 130n to be spaced apart from and insulated from each other.

As shown, the active layer 130 is disposed on the buffer layer 120. The active layer 130 can be formed by a semiconductor material. According to one example of the present disclosure, the active layer 130 may include an oxide semiconductor material.

Referring to FIGS. 1A to 1D, the active layer 130 includes a first active layer 131 and a second active layer 132 on the first active layer 131. The first active layer 131 can be disposed to overlap the second active layer 132. In addition, the second active layer 132 can have a mobility greater than that of the first active layer 131. As a result, in the thin film transistor 100, the second active layer 132 may serve as a main layer of a current flow. According to one example of the present disclosure, the second active layer 132 can have a mobility that is twice or greater than that of the first active layer 131. The second active layer 132 can have a mobility of 2 to 5 times as compared with the first active layer 131.

For example, the first active layer 131 can have a mobility of $5cm^2/V \cdot s$ to $25cm^2/V \cdot s$. In more detail, the first active layer 131 can have a mobility of $5cm^2/V \cdot s$ to $15cm^2/V \cdot s$, or can have a mobility of about $10 \ cm^2/V \cdot s$. The second active layer 132 can have a mobility of $20cm^2/V \cdot s$ or more. In more detail, the second active layer 132 can have a mobility of $20cm^2/V \cdot s$ to $50cm^2/V \cdot s$. In more detail, the second active layer 132 can have a mobility in the range of $20cm^2/V \cdot s$ to $40cm^2/V \cdot s$ or $20cm^2/V \cdot s$ to $30cm^2/V \cdot s$.

Further, the second active layer 132 can have a mobility greater than that of the first active layer 131 as much as $10cm^2/V \cdot s$ to $40cm^2/V \cdot s$. The second active layer 132 can have a mobility greater than that of the first active layer 131 as much as $10cm^2/V \cdot s$ to $30 \ cm^2/V \cdot s$, $10cm^2/V \cdot s$ to $20cm^2/V \cdot s$, or $20cm^2/V \cdot s$ to $30cm^2/V \cdot s$.

The first active layer 131 can include an oxide semiconductor material having excellent stability. In addition, the first oxide semiconductor layer 131 supports the second oxide semiconductor layer 132. Therefore, the first oxide semiconductor layer 131 is also referred to as a "support layer." The first active layer 131 can include at least one of, for example, an IGZO(InGaZnO)-based oxide semiconductor material, a GZO(GaZnO)-based oxide semiconductor material, an IGO(InGaO)-based oxide semiconductor material, or a GZTO(GaZnSnO)-based oxide semiconductor material. When the oxide semiconductor material constituting the first active layer 131 includes gallium (Ga) and indium (In), a concentration of gallium (Ga) is set to be higher than that of indium (In) based on the number of moles [Ga concentration > In concentration].

The second active layer 132 can include an oxide semiconductor material having high mobility. The second active layer 132 may include at least one of, for example, an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based semiconductor material, a ZnO-based oxide semiconductor material, a SIZO(SiInZnO)-based oxide semiconductor material, or a ZnON(Zn-Oxynitride)-based oxide semiconductor material. When the oxide semiconductor material constituting the second active layer 132 includes gallium (Ga) and indium (In), a concentration of indium (In) is set to be higher than that of gallium (Ga) based on the number of moles [Ga concentration < In concentration].

However, the type of the oxide semiconductor material is not limited to the above example, and the first active layer 131 and the second active layer 132 can include other oxide semiconductor materials known in the art. Referring to FIGS. 1A, 1C and 1D, the active layer 130 includes a channel portion 130n, a first connection portion 130a contacting one side of the channel portion 130n, and a second connection portion 130b contacting the other side of the channel portion 130n.

The channel portion 130n overlaps the gate electrode 150, and serves as a channel of the thin film transistor 100. One side of the channel portion 130n contacts the first connection portion 130a, and the other side of the channel portion 130n contacts the second connection portion 130b.

As shown, the first connection portion 130a and the second connection portion 130b of the active layer 130 do not overlap the gate electrode 150. In addition, the first connection portion 130a and the second connection portion 130b can be formed by selective conductorization of a semiconductor material. According to one example of the present disclosure, providing a conductivity to a selected portion of the active layer 130 will be referred to as selective conductorization. The selective conductorization can be performed by doping, plasma treatment or the like.

For example, selective conductorization for the active layer 130 can be performed by dopant doping using the gate electrode 150 or photoresist as a mask. Implantation of dopant ions into a selected area of the active layer 130 will be referred to as dopant doping. The dopant may include at least one of, for example, boron (B), phosphorus (P), fluorine (F) or hydrogen (H).

When the selective conductorization for the active layer 130 is performed by dopant doping or implantation, an area doped with a dopant in the active layer 130 is selectively conductorized to become the first connection portion 130a or the second connection portion 130b. An area of the active layer 130, which is not doped with a dopant, is not conductorized, and becomes the channel portion 130n.

In addition, the selective conductorization for the active layer 130 can be performed by plasma treatment applied to a process of patterning a gate insulating layer 140. For example, plasma can be used in the process of patterning the gate insulating layer 140, and a portion of the active layer 130, which is in contact with the plasma, can be selectively conductorized to become the first connection portion 130a or the second connection portion 130b. A portion of the active layer 130, which is protected by the gate insulating layer 140 and does not contact the plasma, is not conductorized, and can become the channel portion 130n.

The first connection portion 130a and the second connection portion 130b are portions made of an oxide semiconductor material and then given conductivity. Therefore, the first connection portion 130a and the second connection portion 130b have a greater electrical conductivity than that of the channel portion 130n. That is, by conductorization, the first connection portion 130a and the second connection portion 130b can have an electrical conductivity similar to that of a metal used as an electrical wiring.

Referring to FIG. 1C, the channel portion 130n may include a channel portion 131n of the first active layer 131 and a channel portion 132n of the second active layer 132. The first connection portion 130a includes a first connection portion 131a of the first active layer 131 and a first connection portion 132a of the second active layer 132. Also, the second connection portion 130b includes a second connection portion 131b of the first active layer 131 and a second connection portion 132b of the second active layer 132.

Further, the first connection portion 130a of the active layer 130 can be a source area, and the second connection portion 130b thereof can be a drain area. Therefore, the first connection portion 130a can serve as a source electrode, and the second connection portion 130b can serve as a drain electrode. However, the present disclosure is not limited to the above example, and the first connection portion 130a can be a drain area, and the second connection portion 130b can be a source area.

In addition, the channel portion 130n includes a first overlap area OA1 in which the first active layer 131 and the second active layer 132 overlap each other based on a plan view, and a first non-overlap area NOA1 in which the first active layer 131 and the second active layer 132 do not overlap each other based on the plan view.

As shown, each of the first active layer 131 and the second active layer 132 in the channel portion 130n extends from the first connection portion 130a to the second connection portion 130b. As a result, the first overlap area OA1 can extend from the first connection portion 130a to the second connection portion 130b. In addition, the first non-overlap area NOA1 can be extend from the first connection portion 130a to the second connection portion 130b.

Because the first overlap area OA1 and the first non-overlap area NOA1 can be extended from the first connection portion 130a to the second connection portion 130b, both the first overlap area OA1 and the first non-overlap area NOA1 can serve as channels of the thin film transistor 100.

Referring to FIGS. 1A and 1B, the second active layer 132 can be disposed in the entire area of the channel portion 130n based on the plan view. In addition, the first active layer 131 can be disposed only in the first overlap area OA1 without being disposed in the first non-overlap area NOA1. According to one example of the present disclosure, in the channel portion 130n, the second active layer 132 can cover an entire upper surface of the first active layer 131.

FIG. 1C is a cross-sectional view illustrating a first overlap area OA1, and FIG. 1D is a cross-sectional view illustrating a first non-overlap area NOA1. As shown in FIGS. 1C and 1D, the first active layer 131 and the second active layer 132 are disposed to overlap each other in the first overlap area OA1, whereas only the second active layer 132 is disposed in the first non-overlap area NOA1. Therefore, the first overlap area OA1 can have a carrier that is more abundant than that of the first non-overlap area NOA1. In more detail, the first overlap area OA1 can have an electron carrier that is more abundant than that of the first non-overlap area NOA1.

As a result, the ON-current of the thin film transistor 100 can be improved by the first overlap area OA1. Therefore, the thin film transistor 100 having the first overlap area OA1 can have excellent current characteristics.

Also, the first non-overlap area NOA1 has a carrier having a concentration lower than that of the first overlap area OA1. In more detail, the first non-overlap area NOA1 can have an electron carrier of a concentration lower than that of the first overlap area OA1. Therefore, before the thin film transistor 100 is completely turned on by applying a gate voltage, a current increase rate of the thin film transistor can be delayed. As a result, an s-factor (sub-threshold swing) of the thin film transistor 100 can be increased.

As described above, the channel portion 130n includes the first overlap area OA1 and the first non-overlap area NOA1 together, so that the ON-current of the thin film transistor 100 can be improved and at the same time, the s-factor can be increased.

Referring to FIGS. 1B-1D, the gate insulating layer 140 is disposed on the active layer 130 and protects the channel portion 130n. The gate insulating layer 140 can include at least one of silicon oxide, silicon nitride or metal-based oxide and can have a single-layered structure or a multi-layered structure.

Referring to FIGS. 1B to 1D, the gate insulating layer 140 can be integrally formed on the entire surface of the substrate 110, but the present disclosure is not limited thereto, and the gate insulating layer 140 can be patterned. For example, the gate insulating layer 140 can be patterned to have a shape corresponding to that of the gate electrode 150.

Further, the gate electrode 150 is disposed on the gate insulating layer 140 and overlaps the channel portion 130n of the active layer 130. The gate electrode 150 can include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti). The gate electrode 150 can also have a multi-layered structure that includes at least two conductive layers having their respective physical properties different from each other.

An interlayer insulating layer 170 is disposed on the gate electrode 150 and is an insulating layer made of an insulating material. The interlayer insulating layer 170 can be made of an organic material or an inorganic material, or can be made of a stacked body of an organic material layer and an inorganic material layer.

A source electrode 161 and a drain electrode 162 are disposed on the interlayer insulating layer 170. As shown, the source electrode 161 is connected to the active layer 130 through a contact hole H2. In more detail, the source electrode 161 can be electrically connected to the first connection portion 130a of the active layer 130 through the contact hole H2. The source electrode 161 can also be connected to the light shielding layer 111 through a contact hole H1. As a result, the light shielding layer 111 can be connected to the first connection portion 130a of the active layer 130.

In addition, the drain electrode 162 is spaced apart from the source electrode 161 and is thus connected to the active layer 130 through a contact hole H3. In more detail, the drain electrode 162 can be electrically connected to the second connection portion 130b of the active layer 130 through a contact hole H3.

Each of the source electrode 161 and the drain electrode 162 can include at least one of molybdenum (Mo), aluminum (Al), chromium (Cr), gold (Au), titanium (Ti), nickel (Ni), neodymium (Nd), copper (Cu) or their alloy. Each of the source electrode 161 and the drain electrode 162 can also be formed of a single layer made of a metal or a metal alloy, or can be formed of a multilayer of two or more layers.

However, the present disclosure is not limited to the above example, and the first connection portion 130a can be a source electrode and an electrode indicated by a reference numeral "161" can be a connection electrode or a bridge. Likewise, the second connection portion 130b can be a drain electrode and an electrode indicated by a reference numeral "162" can be a connection electrode or a bridge.

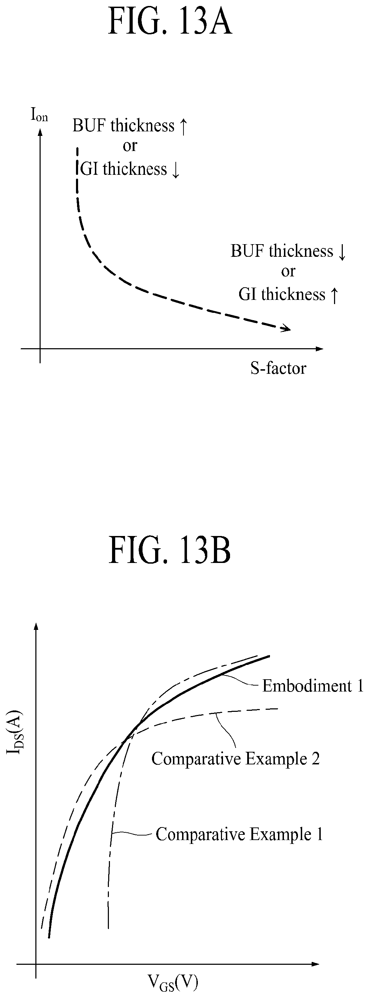

Hereinafter, the s-factor will be described in more detail. At a threshold voltage Vth of a drain-source current graph for a gate voltage of the thin film transistor 100, the s-factor (sub-threshold swing) can be used as an index indicating a change level of the drain-source current for the gate voltage. The s-factor can be described by a current-change graph shown in FIG. 13B, for example.

In particular, FIG. 13B illustrates a drain-source current $I_{DS}$ for a gate voltage $V_{GS}$. At the threshold voltage Vth of the thin film transistor 100, a reciprocal of a slope in the graph of the drain-source current $I_{DS}$ for the gate voltage $V_{GS}$ can be defined as the s-factor. When the slope of the graph is steep, the s-factor is small, and when the slope of the graph is small, the s-factor is large. When the s-factor is large, a change rate of the drain-source current $I_{DS}$ for the gate voltage at a period of the threshold voltage Vth is slow. When the s-factor is large, since the change rate of the drain-source current $I_{DS}$ for the gate voltage is slow, it is easy to adjust a magnitude of the drain-source current $I_{DS}$ by adjusting the gate voltage $V_{GS}$.

In the display apparatus driven by the current, for example, in an organic light emitting display apparatus, a gray scale of a pixel can be controlled by adjusting the magnitude of the drain-source current $I_{DS}$ of the driving thin film transistor. The magnitude of the drain-source current $I_{DS}$ of the driving thin film transistor is determined by the gate voltage. Therefore, in the organic light emitting display apparatus driven by the current, it is easy to adjust a gray scale of a pixel as the s-factor of the driving thin film transistor TR becomes large.

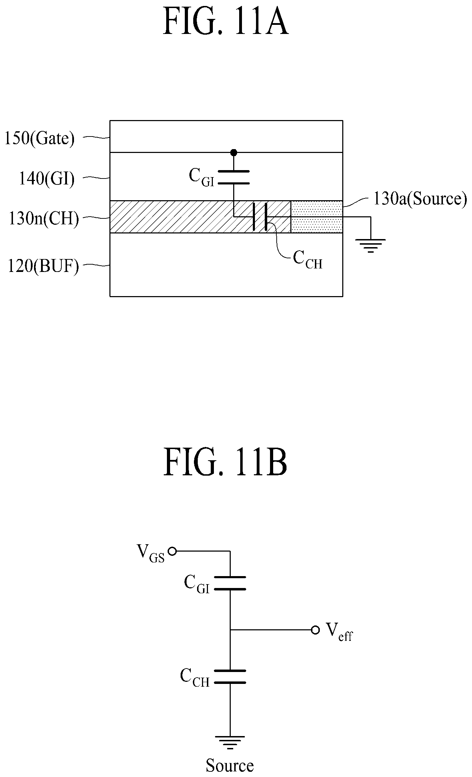

As a method for adjusting the s-factor of the thin film transistor 100 includes adjusting a thickness of the gate insulating layer 140. In more detail, FIGS. 11A and 11B are schematic views illustrating a gate voltage applied to a thin film transistor.

As shown, FIG. 11A schematically illustrates a capacitance Cap that can be generated when a gate voltage $V_{GS}$ is applied to the thin film transistor. In particular, FIG. 11A schematically illustrates a relation of the capacitance Cap and a voltage before the thin film transistor is completely turned on. In FIG. 11A, the gate voltage $V_{GS}$ is a voltage between the source electrode 161 and the gate electrode 150. The gate voltage $V_{GS}$ can be referred to as a voltage between the first connection portion 130a and the gate electrode 150.

As shown in FIG. 11A, when the gate voltage $V_{GS}$ is applied to the thin film transistor, a capacitance $C_{GI}$ can be formed between the channel portion 130n of the active layer 130 and the gate electrode 150 (Gate), and a capacitance $C_{CH}$ can be also formed between the channel portion 130n and the first connection portion 130a (Source). The capacitance $C_{CH}$ formed between the channel portion 130n and the first connection portion 130a (Source) can be referred to as a capacitance formed by a voltage difference between the drain electrode 162, which is a high voltage terminal, and the source electrode 161, which is a low voltage terminal, in the channel portion 130n made of an oxide semiconductor layer having N-type semiconductor characteristics.

The relation between the capacitance Cap and the voltage according to FIG. 11A can be represented as shown in FIG. 11B. Referring to FIG. 11B, due to the capacitance $C_{CH}$ between the channel portion 130n and the first connection portion 130a (Source), not all gate voltages $V_{GS}$ are effectively applied to the channel portion 130n. As a result, voltage loss can be generated.

Referring to FIG. 11B, when one of the gate voltages $V_{GS}$, which is effectively applied to the channel portion 130n during driving of the thin film transistor, is referred to as an effective gate voltage $V_{eff}$, the effective gate voltage $V_{eff}$ can be obtained by the following Equation 1.

[Equation 1]

$$V_{eff} = [C_{GI} / (C_{GI} + C_{CH})] \times V_{GS}$$

In order to increase the s-factor of the thin film transistor 100, when the thickness of the gate insulating layer 140 is increased, a capacitance $C_{GI}$ is reduced between the channel portion 130n of the active layer 130 and the gate electrode 150 (Gate), so that an effective gate voltage $V_{eff}$, which is effectively applied to the channel portion 130n, among the gate voltages $V_{GS}$ can be reduced. As a result, the s-factor can be increased, but the effective gate voltage $V_{eff}$ calculated by the Equation 1 is also reduced, and the ON-Current of the thin film transistor 100 is reduced.

On the other hand, according to one example of the present disclosure, because the channel portion 130n includes the first overlap area OA1 and the first non-overlap area NOA1 together, the s-factor of the thin film transistor 100 can be increased without reducing the ON-Current.

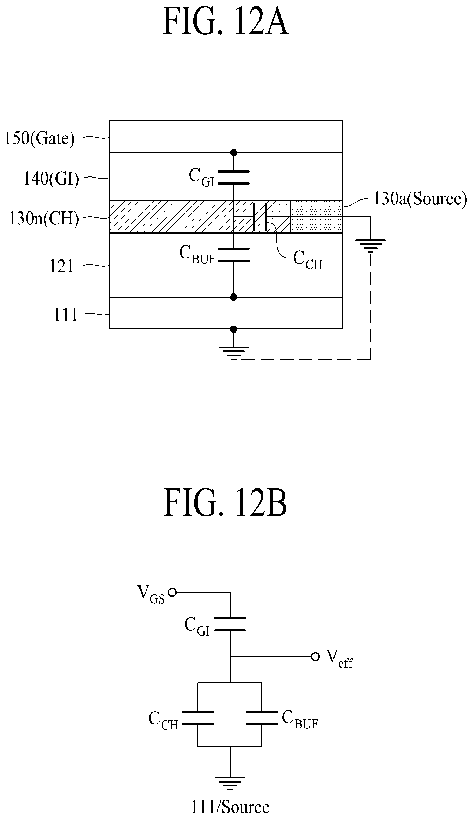

Next, FIGS. 12A and 12B are schematic views illustrating a gate voltage applied to the thin film transistor 100 and describing an example that the light shielding layer 111 is connected to the source electrode 161. As shown in FIG. 12A, when the gate voltage $V_{GS}$ is applied to the thin film transistor 100, the capacitance $C_{GI}$ can be formed between the channel portion 130n of the active layer 130 and the gate electrode 150, the capacitance $C_{CH}$ can be formed between the channel portion 130n and the first connection portion 130a (Source), and a capacitance $C_{BUF}$ can be additionally formed between the channel portion 130n and the light shielding layer 111.

The relation between the capacitance Cap and the voltage according to FIG. 12A can be represented as shown in FIG. 12B. Referring to FIG. 12B, due to the capacitance $C_{CH}$ between the channel portion 130n and the first connection portion 130a (Source) and the capacitance $C_{BUF}$ between the channel portion 130n and the light shielding layer 111, not all gate voltages $V_{GS}$ are effectively applied to the channel portion 130n, and voltage loss can be generated.

When the light shielding layer 111 and the source electrode 161 are electrically connected to each other, the capacitance $C_{BUF}$ is additionally generated between the channel portion 130n and the light shielding layer 111, so that a lower capacitance $C_{CH} + C_{BUF}$ causing a voltage loss is increased. In more detail, when a voltage of the gate voltages $V_{GS}$, which is effectively applied to the channel portion 130n, is referred to as the effective gate voltage Veff in FIG. 12B, the effective gate voltage Veff can be obtained by the following Equation 2.

[Equation 2]

$$V_{eff} = [C_{GI} / (C_{GI} + C_{CH} + C_{BUF})] \times V_{GS}$$

Referring to the Equation 2, a denominator value of the Equation 2 is increased due to the capacitance $C_{BUF}$ formed between the channel portion 130n and the light shielding layer 111. Therefore, when the capacitance $C_{BUF}$ between the channel portion 130n and the light shielding layer 111 is increased, the effective gate voltage Veff is reduced, whereby the increase rate of the drain-source current $I_{DS}$ in the thin film transistor 100 is reduced. As a result, the s-factor is increased.

Referring to the Equation 2, the capacitance $C_{BUF}$ between the channel portion 130n and the light shielding layer 111 can be increased to increase the s-factor of the thin film transistor 100. A method for increasing the capacitance $C_{BUF}$ between the channel portion 130n and the light shielding layer 111 includes reducing a thickness of the buffer layer 120. However, when the thickness of the buffer layer 120 is reduced, the channel portion 130n of the thin film transistor 100 can be damaged by hydrogen, oxygen or moisture, and the ON-current of the thin film transistor 100 is reduced.

According to one example of the present disclosure, because the channel portion 130n includes the first overlap area OA1 and the first non-overlap area NOA1 together, the s-factor of the thin film transistor 100 can be increased even though the thickness of the buffer layer 120 is not reduced, and at the same time the ON-current of the thin film transistor 100 can be also increased.

Next, FIG. 2 is a cross-sectional view illustrating a thin film transistor 200 according to another example of the present disclosure. In particular, FIG. 2 corresponds to a cross-section taken along line II-II' of FIG. 1A. Referring to FIG. 2, the gate insulating layer 140 can be patterned without being formed on the entire surface of the substrate 110. For example, as shown in FIG. 2, the gate insulating layer 140 can be patterned in the same planar shape as that of the gate electrode 150.

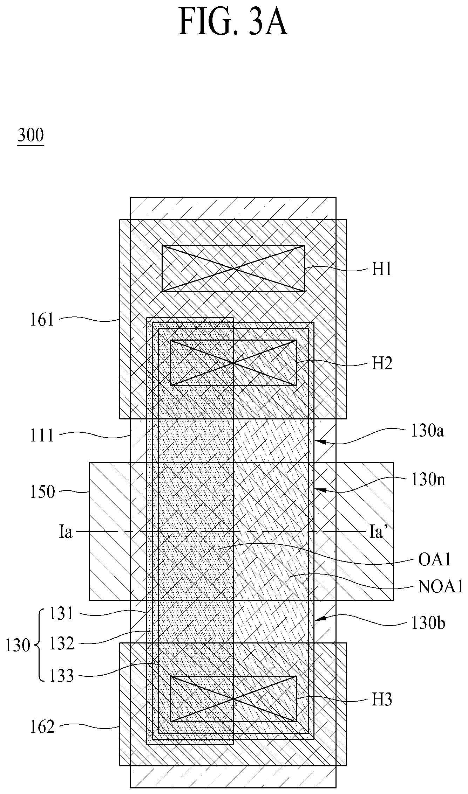

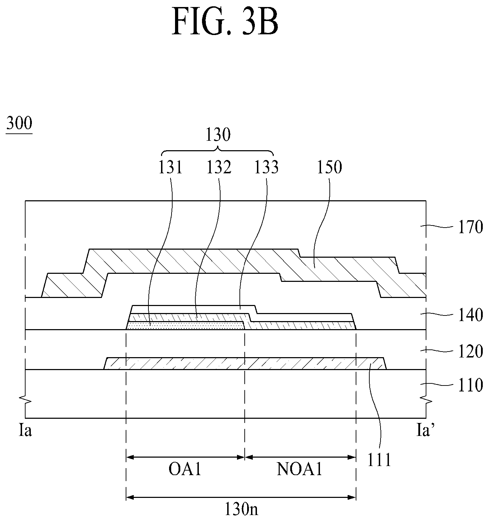

In addition, FIG. 3A is a plan view illustrating a thin film transistor 300 according to still another example of the present disclosure, and FIG. 3B is a cross-sectional view taken along line Ia-Ia' of FIG. 3A. Referring to FIGS. 3A and 3B, the active layer 130 can further include a third active layer 133 on the second active layer 132. The third active layer 133 can be extended from the first connection portion 130a to the second connection portion 130b in the channel portion 130n. The third active layer 133 can also be also disposed in the first connection portion 130a and the second connection portion 130b.

Further, the third active layer 133 can protect the second active layer 132. To protect the second active layer 132, the third active layer 133 can be made of an oxide semiconductor material having an excellent stability. The third active layer 133 can also serve as a protective layer for protecting the second active layer 132.

In addition, the third active layer 133 can have a mobility smaller than that of the third active layer 133. The second active layer 132 can have a mobility greater than that of the third active layer 133 as much as two times or more. In more detail, the second active layer 132 can have a mobility of 2 to 5 times as compared with the third active layer 133. The third active layer 133 can have a mobility of $5cm^2/V \cdot s$ to $25cm^2/V \cdot s$. In more detail, the third active layer 133 can have a mobility of $5cm^2/V \cdot s$ to $15cm^2/V \cdot s$, or can have mobility of about $10 \ cm^2/V \cdot s$.

Further, the second active layer 132 can have a mobility greater than that of the third active layer 133 as much as $10cm^2/V \cdot s$ to $40cm^2/V \cdot s$. The second active layer 132 can also have a mobility greater than that of the third active layer 133 as much as $10cm^2/V \cdot s$ to $30 \ cm^2/V \cdot s$, $10cm^2/V \cdot s$ to $20cm^2/V \cdot s$, or $20cm^2/V \cdot s$ to $30cm^2/V \cdot s$.

The third active layer 133 can include at least one of, for example, an IGZO(InGaZnO)-based oxide semiconductor material, a GZO(GaZnO)-based oxide semiconductor material, an IGO(InGaO)-based oxide semiconductor material, or a GZTO(GaZnSnO)-based oxide semiconductor material. When the oxide semiconductor material constituting the third active layer 133 includes gallium (Ga) and indium (In), a concentration of gallium (Ga) is set to be higher than that of indium (In) based on the number of moles [Ga concentration > In concentration].

Thus, with the third active layer 133, the second active layer 132, which is an intermediate layer in the manufacturing process, can be effectively protected. For example, in the manufacturing process, the first active layer 131 can protect the second active layer 132, which is an intermediate layer, from gas, for example, hydrogen (H), moisture ($H_2O$), oxygen ($O_2$), etc. generated from the buffer layer 120 therebelow or another insulating layer, and the third active layer 133 can protect the second active layer 132, which is an intermediate layer, from an etching solution used during a patterning process or gas, for example, hydrogen (H), moisture ($H_2O$), oxygen ($O_2$), etc. generated from an upper insulating layer, for example, the gate insulating layer 140, the interlayer insulating layer 170, etc.

Referring to FIGS. 3A and 3B, the third active layer 133 can be disposed in the first overlap area OA1 and the first non-overlap area NOA1. The third active layer 133 can be disposed to cover the entire upper surface of the second active layer 132, but the present disclosure is not limited thereto, and the third active layer 133 can cover a portion of the upper surface of the second active layer 132.

Referring to FIGS. 3A and 3B, because the third active layer 133 is disposed in the first non-overlap area NOA1 and also serves as a protective layer for protecting the second active layer 132, an effect of increasing the carrier due to the third active layer 133 is not significant. Therefore, an s-factor of the thin film transistor 300 can be maintained at a high level.

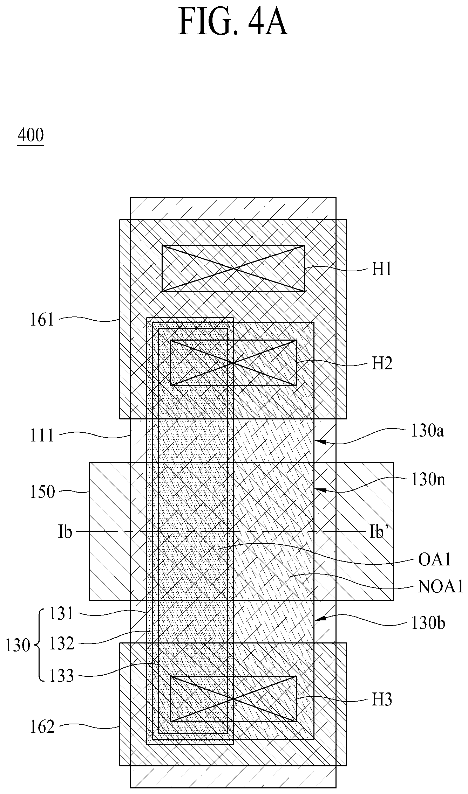

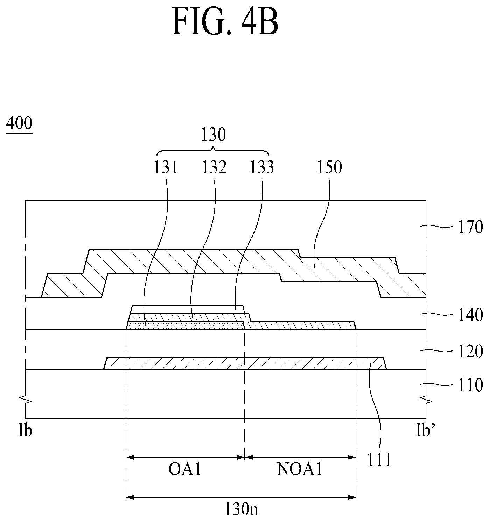

Next, FIG. 4A is a plan view illustrating a thin film transistor 400 according to still another example of the present disclosure, and FIG. 4B is a cross-sectional view taken along line Ib-Ib' of FIG. 4A. Referring to FIGS. 4A and 4B, the active layer 130 can include a third active layer 133 on the second active layer 132, and the third active layer 133 can be disposed on a portion of the upper surface of the second active layer 132. In more detail, the third active layer 133 is not disposed in the first non-overlap area NOA1 and is disposed only in the first overlap area OA1.

The third active layer 133 is disposed in the first overlap area OA1, so that the upper portion of the second active layer 132 can be effectively protected in at least the first overlap area OA1. In addition, the electron carrier of the first overlap area OA1 can be increased due to the carrier included in the third active layer 133. In a structural aspect, a thickness of the first overlap area OA1 is increased due to the third active layer 133, whereby the physical stability of the first overlap area OA1 can be improved. As a result, the stability of the thin film transistor 100 can be improved, and the ON-current of the thin film transistor 100 can be improved by the first overlap area OA1. On the other hand, as the third active layer 133 is not disposed in the first non-overlap area NOA1, the carrier of the first non-overlap area NOA1 is not increased. As a result, an s-factor of the thin film transistor 400 can be maintained at a high level.

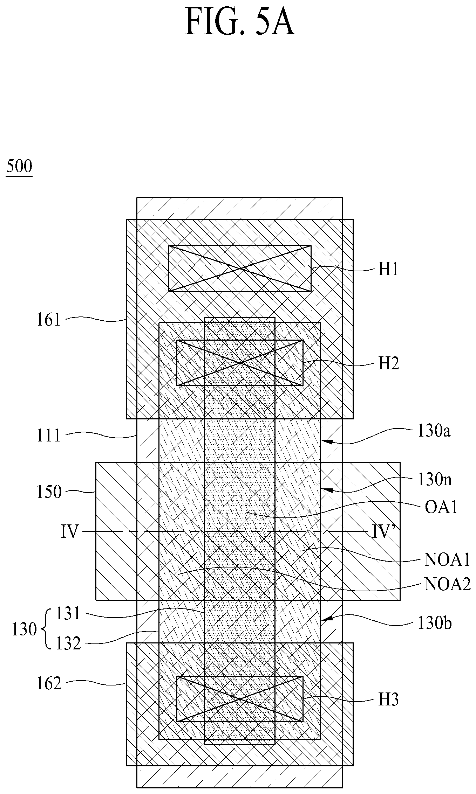

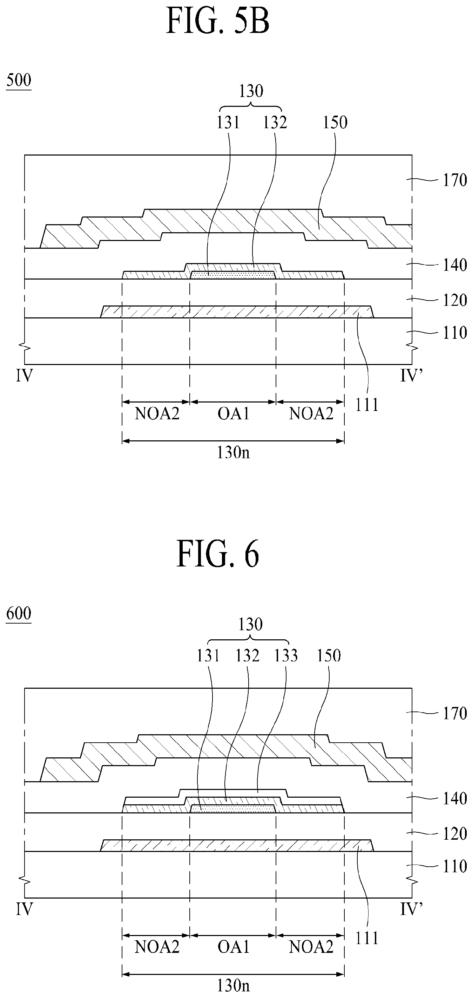

Next, FIG. 5A is a plan view illustrating a thin film transistor 500 according to further still another example of the present disclosure, and FIG. 5B is a cross-sectional view taken along line IV-IV' of FIG. 5A. The thin film transistor 500 of FIG. 5A further includes a second non-overlap area NOA2 as compared with the thin film transistor 100 of FIG. 1A.

Referring to FIGS. 5A and 5B, the channel portion 130n can further include a second non-overlap area NOA in which the first active layer 131 and the second active layer 132 do not overlap each other based on the plan view. The second non-overlap area NOA2 can be spaced apart from the first non-overlap area NOA1 and extend from the first connection portion 130a to the second connection portion 130b. The first non-overlap area NOA1 and the second non-overlap area NOA2 can be disposed to be spaced apart from each other with the first overlap area OA1 interposed therebetween.

As shown, the first active layer 131 may not be disposed in the second non-overlap area NOA2. Further, the second non-overlap area NOA2 includes a carrier (electron carrier) having a concentration lower than that of the first overlap area OA1 in the same manner as the first non-overlap area NOA1. Therefore, the second non-overlap area NOA2 can serve to increase the s-factor of the thin film transistor 100 in the same manner as the first non-overlap area NOA1.

Next, FIG. 6 is a cross-sectional view illustrating a thin film transistor 600 according to further still another example of the present disclosure. In particular, FIG. 6 is a cross-sectional view taken along line IV-IV' of FIG. 5A.

Referring to FIG. 6, the active layer 130 can further include a third active layer 133 on the second active layer 132. The third active layer 133 can be extended from the first connection portion 130a to the second connection portion 130b in the channel portion 130n. The third active layer 133 can also be disposed in the first connection portion 130a and the second connection portion 130b.

In addition, the third active layer 133 can be disposed in the first overlap area OA1, the first non-overlap area NOA1 and the second non-overlap area NOA2. The third active layer 133 can also be disposed to cover the entire upper surface of the second active layer 132, but the present disclosure is not limited thereto, and the third active layer 133 can cover a portion of the upper surface of the second active layer 132.

Referring to FIG. 6, the third active layer 133 is disposed in the first non-overlap area NOA1 and the second non-overlap area NOA2, but an effect of increasing the carrier due to the third active layer 133 is not significant. Therefore, an s-factor of the thin film transistor 600 can be maintained at a high level.

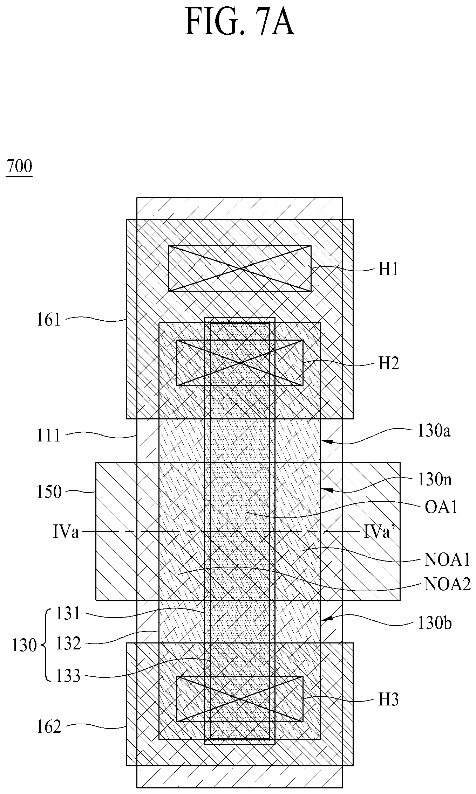

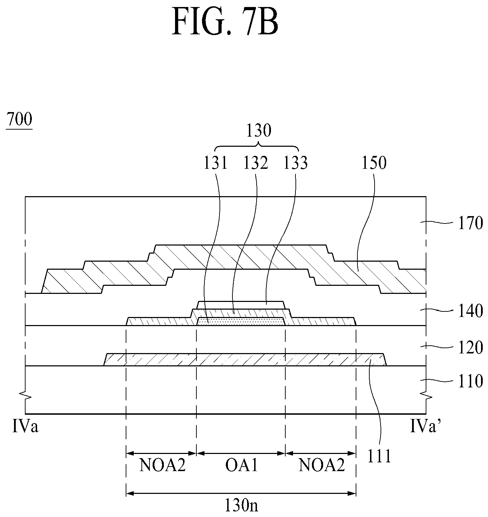

Next, FIG. 7A is a plan view illustrating a thin film transistor 700 according to further still another example of the present disclosure, and FIG. 7B is a cross-sectional view taken along line IVa-IVa' of FIG. 7A. Referring to FIGS. 7A and 7B, the active layer 130 can include a third active layer 133 on the second active layer 132, and the third active layer 133 can be disposed on a portion of the upper surface of the second active layer 132.

In more detail, the third active layer 133 can be disposed in the first overlap area OA1. The third active layer 133 may not be disposed in the first non-overlap area NOA1. In addition, the third active layer 133 may not be disposed in the second non-overlap area NOA2. The third active layer 133 is not disposed in the second non-overlap area NOA2, so that a carrier of the second non-overlap area NOA2 may not be increased. As a result, an s-factor of the thin film transistor 700 can be maintained at a high level.

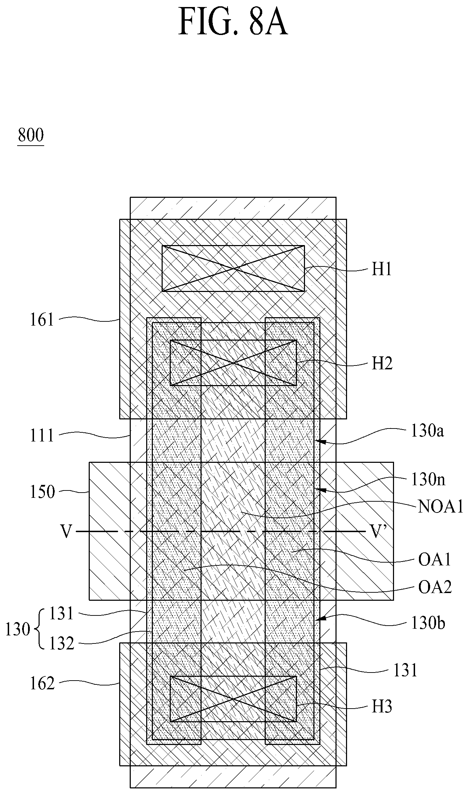

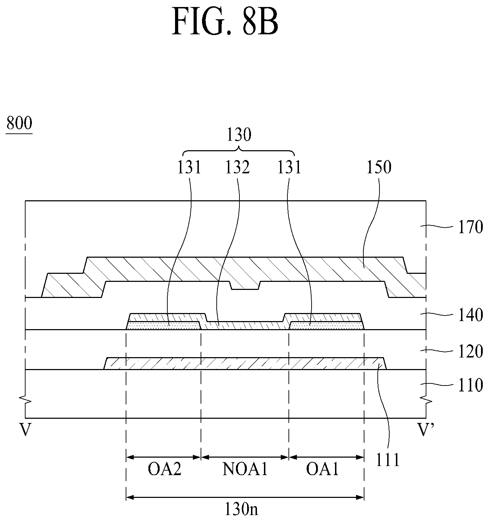

Next, FIG. 8A is a plan view illustrating a thin film transistor 800 according to further still another example of the present disclosure, and FIG. 8B is a cross-sectional view taken along the line V-V' of FIG. 8A. The thin film transistor 800 of FIG. 8A further includes a second overlap area OA2 as compared with the thin film transistor 100 of FIG. 1A.

Referring to FIGS. 8A and 8B, the channel portion 130n can further include a second overlap area OA2 in which the first active layer 131 and the second active layer 132 overlap each other based on the plan view. The second overlap area OA2 can be spaced apart from the first overlap area OA1 and extend from the first connection portion 130a to the second connection portion 130b. In addition, the first overlap area OA1 and the second overlap area OA2 can be spaced apart from each other with the first non-overlap area NOA1 interposed therebetween.

According to one example of the present disclosure, the first active layer 131 is not disposed in the first non-overlap area NOA1, and can be disposed in the first overlap area OA1 and the second overlap area OA2. Also, the second overlap area OA2 includes a carrier (electron carrier) of a concentration higher than that of the first non-overlap area NOA1 in the same manner as the first overlap area OA1. Therefore, the second overlap area OA2 can serve to improve the ON-current of the thin film transistor 100 in the same manner as the first overlap area OA1.

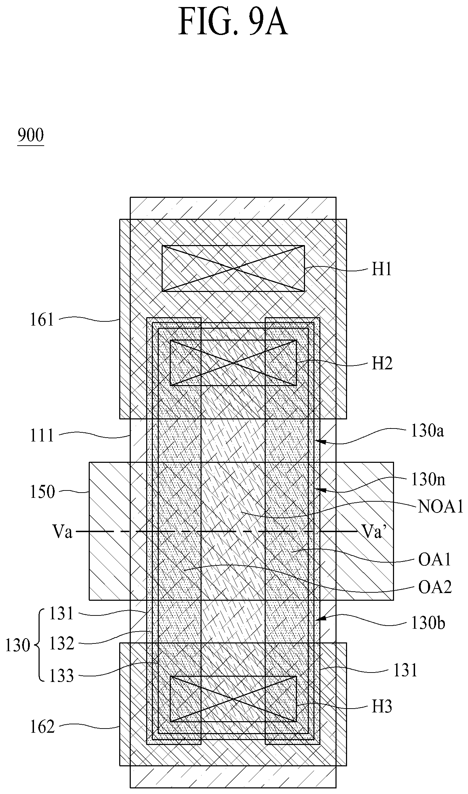

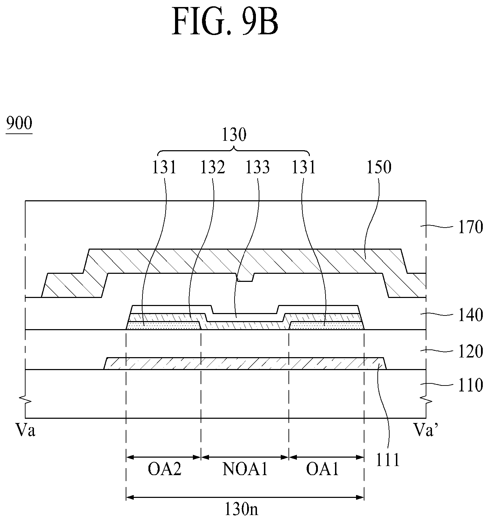

FIG. 9A is a plan view illustrating a thin film transistor 900 according to further still another example of the present disclosure, and FIG. 9B is a cross-sectional view taken along line Va-Va' of FIG. 9A. Referring to FIGS. 9A and 9B, the active layer 130 can further include a third active layer 133 on the second active layer 132. As shown, the third active layer 133 can be extended from the first connection portion 130a to the second connection portion 130b in the channel portion 130n. The third active layer 133 can be also disposed in the first connection portion 130a and the second connection portion 130b.

Further, the third active layer 133 can be disposed in the first overlap area OA1, the first non-overlap area NOA1 and the second overlap area OA2. Also, the third active layer 133 can be disposed to cover the entire upper surface of the second active layer 132, but the present disclosure is not limited thereto, and the third active layer 133 can cover a portion of the upper surface of the second active layer 132.

Referring to FIGS. 9A and 9B, the third active layer 133 is disposed in the first non-overlap area NOA1, but the effect of increasing the carrier due to the third active layer 133 is not significant. Therefore, an s-factor of the thin film transistor 900 can be maintained at a high level.

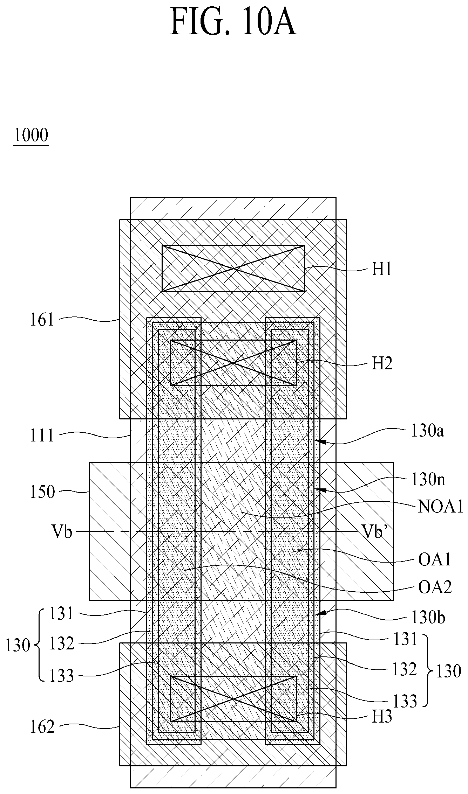

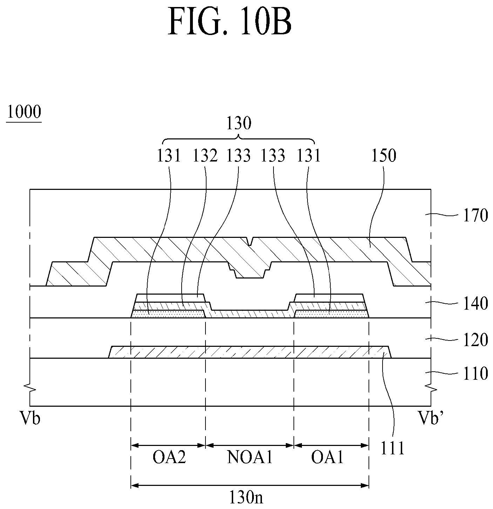

Next, FIG. 10A is a plan view illustrating a thin film transistor 1000 according to further still another example of the present disclosure, and FIG. 10B is a cross-sectional view taken along the line Vb-Vb' of FIG. 10A. Referring to FIGS. 10A and 10B, the active layer 130 can include a third active layer 133 on the second active layer 132, and the third active layer 133 can be disposed on a portion of the upper surface of the second active layer 132. In more detail, the third active layer 133 can be disposed in the first overlap area OA1 and the second overlap area OA2. The third active layer 133 may not be disposed in the first non-overlap area NOA1.

As the third active layer 133 is not disposed in the first non-overlap area NOA1, the carrier of the first non-overlap area NOA1 is not increased. As a result, an s-factor of the thin film transistor 1000 can be maintained at a high level.

As described previously, FIGS. 11A and 11B are schematic views illustrating a gate voltage applied to a thin film transistor in which the light shielding layer 111 is not disposed, and FIGS. 12A and 12B are schematic views illustrating a gate voltage applied to a thin film transistor in which the light shielding layer 111 is disposed.

As described previously, FIG. 13A is a graph illustrating a relation between an s-factor and an ON-current. In addition, FIG. 13B is a graph illustrating threshold voltages of thin film transistors. Referring to FIG. 13A, in the thin film transistor in which the light shielding layer 111 is disposed, when the thickness of the buffer layer BUF 120 is increased or the thickness of the gate insulating layer GI 140 is reduced, the ON-current of the thin film transistor can be increased, but the s-factor can be reduced.

On the other hand, in the thin film transistor in which the light shielding layer 111 is disposed, when the thickness of the buffer layer BUF 120 is reduced or the thickness of the gate insulating layer GI 140 is increased, the s-factor of the thin film transistor can be increased, but the ON-current can be reduced.

FIG. 13B illustrates threshold voltages of various thin film transistors. In FIG. 13B, "Example 1" is a threshold voltage graph for the thin film transistor 100 of FIG. 1, "Comparative Example 1" is a threshold voltage graph of a thin film transistor in which the thickness of the gate insulating layer 140 is reduced to improve the ON-Current, and "Comparative Example 2" is a threshold voltage graph of a thin film transistor in which the thickness of the gate insulating layer 140 is increased to improve the s-factor.

Referring to the "Comparative Example 1 ," when the thickness of the gate insulating layer 140 is reduced, the ON-current of the thin film transistor is improved but the s-factor is reduced. In addition, referring to the "Comparative Example 2 ," when the thickness of the gate insulating layer 140 is increased, the s-factor of the thin film transistor is increased but the ON-current is reduced. On the other hand, the thin film transistor of the Example 1 according to example 1 of the present disclosure has excellent ON-current characteristics while having a large s-factor.

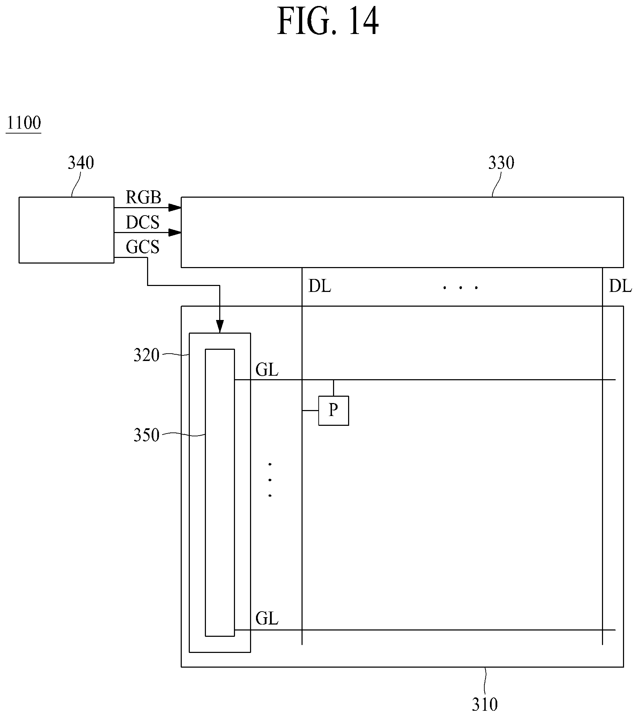

Hereinafter, the display apparatus comprising the above-described thin film transistors 100, 200, 300, 400, 500, 600, 700, 800, 900 and 1000 will be described in detail. In particular, FIG. 14 is a schematic view illustrating a display apparatus 1100 according to further still another example of the present disclosure.

As shown in FIG. 14, the display apparatus 1100 according to further still another example of the present disclosure includes a display panel 310, a gate driver 320, a data driver 330 and a controller 340. Gate lines GL and data lines DL are disposed in the display panel 310, and pixels P are disposed in intersection areas of the gate lines GL and the data lines DL. An image is displayed by driving of the pixels P.

The controller 340 controls the gate driver 320 and the data driver 330. In addition, the controller 340 outputs a gate control signal GCS for controlling the gate driver 320 and a data control signal DCS for controlling the data driver 330 by using a signal supplied from an external system. Also, the controller 340 samples input image data input from the external system, realigns the sampled data and supplies the realigned digital image data RGB to the data driver 330.

The gate control signal GCS includes a gate start pulse GSP, a gate shift clock GSC, a gate output enable signal GOE, a start signal Vst and a gate clock GCLK. Also, control signals for controlling a shift register can be included in the gate control signal GCS. The data control signal DCS includes a source start pulse SSP, a source shift clock signal SSC, a source output enable signal SOE and a polarity control signal POL.

The data driver 330 supplies a data voltage to the data lines DL of the display panel 310. In more detail, the data driver 330 converts the image data RGB input from the controller 340 into an analog data voltage and supplies the data voltage to the data lines DL. The gate driver 320 may include a shift register 350.

In addition, the shift register 350 sequentially supplies gate pulses to the gate lines GL for one frame by using the start signal and the gate clock, which are transmitted from the controller 340. In this instance, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

According to one example of the present disclosure, the gate driver 320 can be packaged on the substrate 110. In this way, a structure in which the gate driver 320 is directly packaged on the substrate 110 will be referred to as a Gate In Panel (GIP) structure.

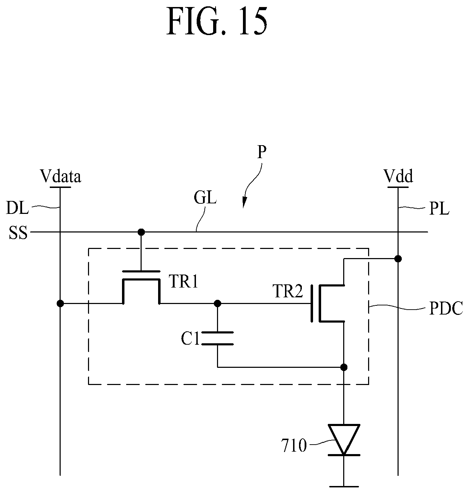

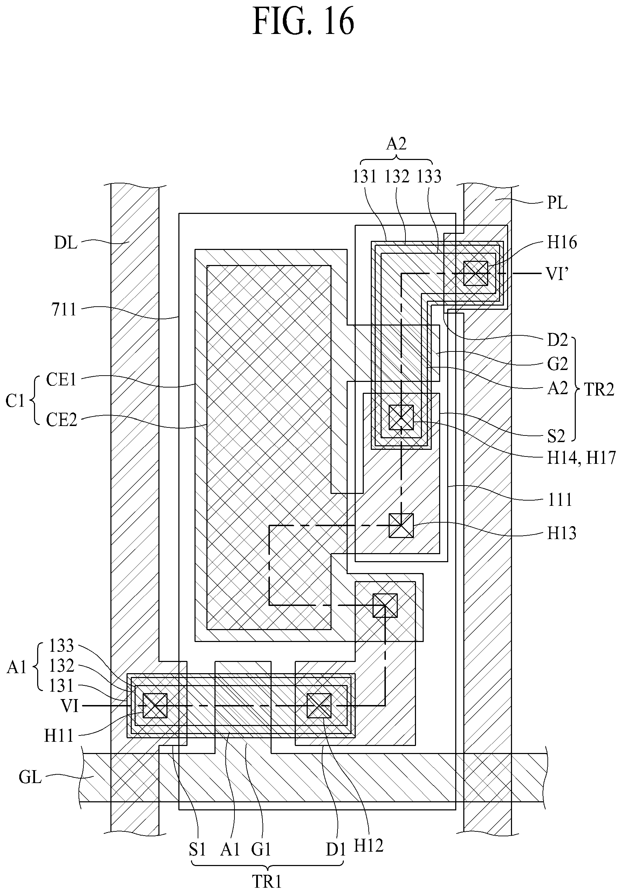

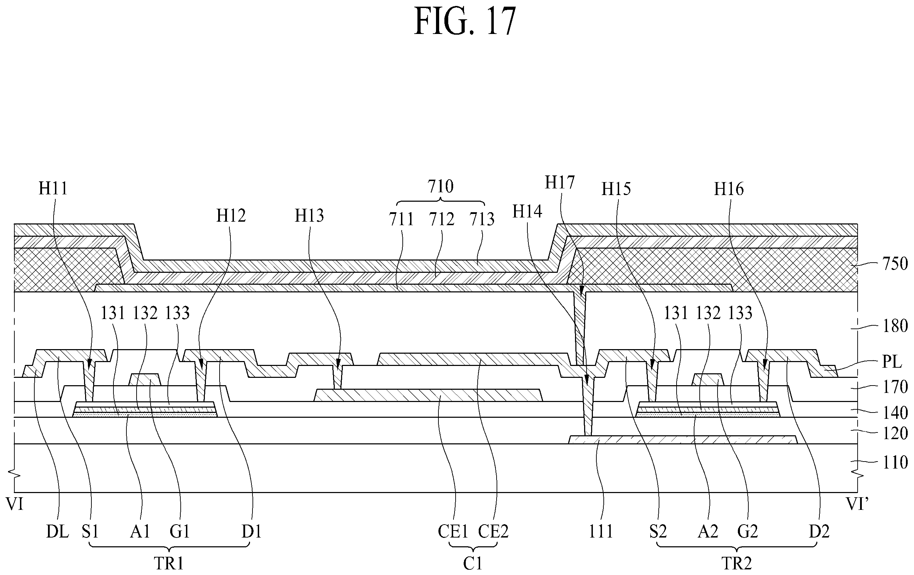

Next, FIG. 15 is a circuit view illustrating any one pixel P of FIG. 14, FIG. 16 is a plan view illustrating a pixel P of FIG. 14, and FIG. 17 is a cross-sectional view taken along line VI-VI' of FIG. 16. The circuit view of FIG. 15 is an equivalent circuit view for the pixel P of the display apparatus 1100 that includes an organic light emitting diode (OLED) as a display device 710.

As shown, the pixel P includes a display device 710 and a pixel driving circuit PDC for driving the display device 710. The pixel driving circuit PDC of FIG. 15 includes a first thin film transistor TR1 that is a switching transistor and a second thin film transistor TR2 that is a driving transistor. For example, the thin film transistors 100, 200, 300, 400, 500, 600, 700, 800, 900 and 1000 described in the examples can be used as the second thin film transistor TR2. The thin film transistors 100, 200, 300, 400, 500, 600, 700, 800, 900 and 1000 described in the examples can be also used as the first thin film transistor TR1.

As shown, the first thin film transistor TR1 is connected to the gate line GL and the data line DL, and is turned on or off by the scan signal SS supplied through the gate line GL. The data line DL provides a data voltage Vdata to the pixel driving circuit PDC, and the first thin film transistor TR1 controls applying of the data voltage Vdata.

A driving power line PL provides a driving voltage Vdd to the display device 710, and the second thin film transistor TR2 controls the driving voltage Vdd. In addition, the driving voltage Vdd is a pixel driving voltage for driving the organic light emitting diode (OLED) that is the display device 710.

When the first thin film transistor TR1 is turned on by the scan signal SS applied from the gate driver 320 through the gate line GL, the data voltage Vdata supplied through the data line DL is supplied to a gate electrode G2 of the second thin film transistor TR2 connected with the display device 710. Further, the data voltage Vdata is charged in a first capacitor C1 formed between the gate electrode G2 and a source electrode S2 of the second thin film transistor TR2. The first capacitor C1 is a storage capacitor Cst.

The amount of a current supplied to the organic light emitting diode (OLED), which is the display device 710, through the second thin film transistor TR2 is controlled in accordance with the data voltage Vdata, whereby a gray scale of light emitted from the display device 710 can be controlled.

Referring to FIGS. 16 and 17, the first thin film transistor TR1 and the second thin film transistor TR2 are disposed on the substrate 110. The substrate 110 can be made of glass or plastic. Plastic having a flexible property, for example, polyimide (PI) can be used as the substrate 110.

The light shielding layer 111 is disposed on the substrate 110. Referring to FIGS. 16 and 17, the light shielding layer 111 is disposed only below the second thin film transistor TR2 that is a driving transistor, but the present disclosure is not limited thereto, and the light shielding layer 111 can be also disposed below the first thin film transistor TR1.

A buffer layer 120 is disposed on the light shielding layer 111. The buffer layer 120 is made of an insulating material, and protects active layers A1 and A2 from external moisture or oxygen. The active layer A1 of the first thin film transistor TR1 and the active layer A2 of the second thin film transistor TR2 are disposed on the buffer layer 120. The active layers A1 and A2 may include, for example, a first active layer 131, a second active layer 132 and a third active layer 133. The active layers A1 and A2 can have any one of the structures of FIGS. 3, 4, 6, 7, 9 and 10.

In addition, a gate insulating layer 140 is disposed on the active layers A1 and A2. The gate insulating layer 140 may cover entire upper surfaces of the active layers A1 and A2, or may cover only a portion of the active layers A1 and A2. The gate electrode G1 of the first thin film transistor TR1 and the gate electrode G2 of the second thin film transistor TR2 are disposed on the gate insulating layer 140. Also, a first capacitor electrode CE1 can be disposed on the gate insulating layer 140. The first capacitor electrode CE1 can be connected to the gate electrode G2 of the second thin film transistor TR2.

An interlayer insulating layer 170 is disposed on the gate electrodes G1 and G2 and the first capacitor electrode CE1. The data line DL, the driving power line PL, source electrodes S1 and S2 and drain electrodes D1 and D2 are disposed on the interlayer insulating layer 170. A portion of the data line DL can be extended to become the source electrode S1 of the first thin film transistor TR1. The source electrode S1 of the first thin film transistor TR1 can be connected to the active layer A1 of the first thin film transistor TR1 through a contact hole H11.

Referring to FIGS. 16 and 17, the drain electrode D1 of the first thin film transistor TR1 and the source electrode S2 of the second thin film transistor TR2 are disposed on the interlayer insulating layer 170. The drain electrode D1 of the first thin film transistor TR1 can be connected to the active layer A1 of the first thin film transistor TR1 through a contact hole H12. In addition, the drain electrode D1 of the first thin film transistor TR1 can be connected to the first capacitor electrode CE1 through a contact hole H13. As a result, the data voltage can be applied to the first capacitor electrode CE1 and the gate electrode G2 of the second thin film transistor TR2.

The source electrode S2 of the second thin film transistor TR2 can be connected to the light shielding layer 111 through one contact hole H14, and can be connected to the active layer A2 of the second thin film transistor TR2 through another contact hole H15. As a result, the light shielding layer 111 can be connected to the source electrode S2 of the second thin film transistor TR2.

In addition, the source electrode S2 of the second thin film transistor TR2 can be extended to become a second capacitor electrode CE2. The second capacitor electrode CE2 overlaps the first capacitor electrode CE1 to form the first capacitor C1. A portion of the driving power line PL can be extended to become the drain electrode D2 of the second thin film transistor TR2. The drain electrode D2 of the second thin film transistor TR2 can be connected to the active layer A2 of the second thin film transistor TR2 through a contact hole H16.

A planarization layer 180 is disposed on the data line DL, the driving power line PL, the source electrodes S1 and S2, the drain electrodes D1 and D2 and the second capacitor electrode CE2. The planarization layer 180 planarizes upper portions of the first thin film transistor TR1 and the second thin film transistor TR2 and protects the first thin film transistor TR1 and the second thin film transistor TR2.

Further, a first electrode 711 of the display device 710 is disposed on the planarization layer 180. The first electrode 711 of the display device 710 contacts the source electrode S2 of the second thin film transistor TR2 and the second capacitor electrode CE2 through a contact hole H17 formed in the planarization layer 180.

Also, a bank layer 750 is disposed at an edge of the first electrode 711. The bank layer 750 defines a light emission area of the display device 710. An organic light emitting layer 712 is further disposed on the first electrode 711, and a second electrode 713 is disposed on the organic light emitting layer 712. Therefore, the display device 710 is completed. The display device 710 shown in FIG. 17 is an organic light emitting diode (OLED). Therefore, the display apparatus 1100 according to one example of the present disclosure is an organic light emitting display apparatus.

According to another example of the present disclosure, the second thin film transistor TR2 can have a large s-factor. The second thin film transistor TR2 can be used as a driving transistor to improve a gray scale representation capability of the display apparatus 1100.

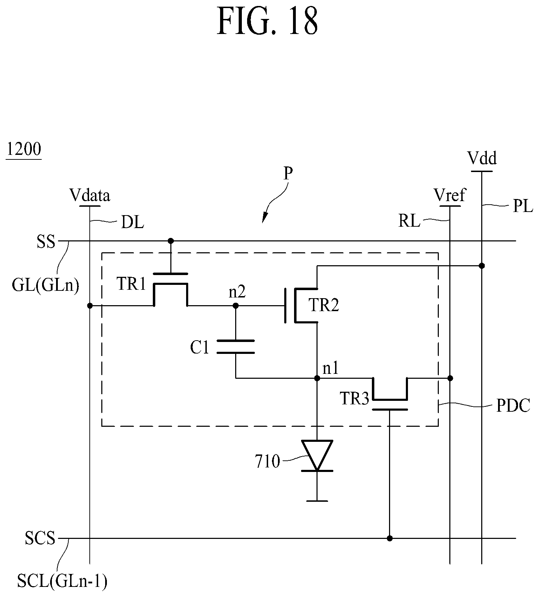

Next, FIG. 18 is a circuit view illustrating any one pixel P of a display apparatus 1200 according to further still another example of the present disclosure. In particular, FIG. 18 is an equivalent circuit view illustrating a pixel P of an organic light emitting display apparatus.

The pixel P of the display apparatus 1200 shown in FIG. 18 includes an organic light emitting diode (OLED) that is a display device 710 and a pixel driving circuit PDC for driving the display device 710. The display device 710 is connected with the pixel driving circuit PDC. In the pixel P, signal lines DL, GL, PL, RL and SCL for supplying a signal to the pixel driving circuit PDC are disposed.

The data voltage Vdata is supplied to the data line DL, the scan signal SS is supplied to the gate line GL, the driving voltage Vdd for driving the pixel is supplied to the driving power line PL, a reference voltage Vref is supplied to a reference line RL, and a sensing control signal SCS is supplied to a sensing control line SCL.

Referring to FIG. 18, assuming that a gate line of an (n)th pixel P is "$GL_n$," a gate line of an (n-1)th pixel P adjacent to the (n)th pixel P is "$GL_{n-1}$" and the gate line "$GL_{n-1}$" of the (n-1)th pixel P serves as a sensing control line SCL of the (n)th pixel P. The pixel driving circuit PDC includes, for example, a first thin film transistor TR1 (switching transistor) connected with the gate line GL and the data line DL, a second thin film transistor TR2 (driving transistor) for controlling a magnitude of a current output to the display device 710 in accordance with the data voltage Vdata transmitted through the first thin film transistor TR1, and a third thin film transistor TR3 (reference transistor) for sensing characteristics of the second thin film transistor TR2.

A first capacitor C1 is positioned between the gate electrode G2 of the second thin film transistor TR2 and the display device 710. The first capacitor C1 is referred to as a storage capacitor Cst. The first thin film transistor TR1 is turned on by the scan signal SS supplied to the gate line GL to transmit the data voltage Vdata, which is supplied to the data line DL, to the gate electrode G2 of the second thin film transistor TR2.

The third thin film transistor TR3 is connected to a first node n1 between the second thin film transistor TR2 and the display device 710 and the reference line RL, and thus is turned on or off by the sensing control signal SCS and senses characteristics of the second thin film transistor TR2, which is a driving transistor, for a sensing period. A second node n2 connected with the gate electrode G2 of the second thin film transistor TR2 is connected with the first thin film transistor TR1. The first capacitor C1 is formed between the second node n2 and the first node n1.

When the first thin film transistor TR1 is turned on, the data voltage Vdata supplied through the data line DL is supplied to the gate electrode G2 of the second thin film transistor TR2. The data voltage Vdata is charged in the first capacitor C1 formed between the gate electrode G2 and the source electrode S2 of the second thin film transistor TR2. When the second thin film transistor TR2 is turned on, the current is supplied to the display device 710 through the second thin film transistor TR2 in accordance with the driving voltage Vdd for driving the pixel, whereby light is output from the display device 710.

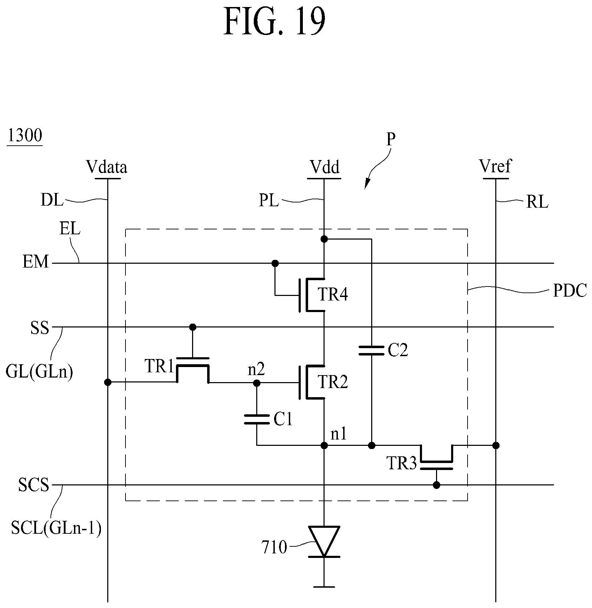

Next, FIG. 19 is a circuit view illustrating any one pixel of a display apparatus 1300 according to further still another example of the present disclosure. The pixel P of the display apparatus 1300 shown in FIG. 19 includes an organic light emitting diode (OLED) that is a display device 710 and a pixel driving circuit PDC for driving the display device 710. The display device 710 is connected with the pixel driving circuit PDC.

The pixel driving circuit PDC includes thin film transistors TR1, TR2, TR3 and TR4. In the pixel P, signal lines DL, EL, GL, PL, SCL and RL for supplying a driving signal to the pixel driving circuit PDC are disposed. In comparison with the pixel P of FIG. 18, the pixel P of FIG. 19 further includes an emission control line EL. An emission control signal EM is supplied to the emission control line EL. Also, the pixel driving circuit PDC of FIG. 19 further includes a fourth thin film transistor TR4 that is an emission control transistor for controlling a light emission timing of the second thin film transistor TR2, in comparison with the pixel driving circuit PDC of FIG. 18.

Referring to FIG. 19, assuming that a gate line of an (n)th pixel P is "$GL_n$," a gate line of an (n-1)th pixel P adjacent to the (n)th pixel P is "$GL_{n-1}$" and the gate line "$GL_{n-1}$" of the (n-1)th pixel P serves as a sensing control line SCL of the (n)th pixel P. A first capacitor C1 is positioned between the gate electrode G2 of the second thin film transistor TR2 and the display device 710. Also, a second capacitor C2 is positioned between one of terminals of the fourth thin film transistor TR4, to which a driving voltage Vdd is supplied, and one electrode of the display device 710.

The first thin film transistor TR1 is turned on by the scan signal SS supplied to the gate line GL to transmit the data voltage Vdata, which is supplied to the data line DL, to the gate electrode G2 of the second thin film transistor TR2. The third thin film transistor TR3 is connected to the reference line RL, and thus is turned on or off by the sensing control signal SCS and senses characteristics of the second thin film transistor TR2, which is a driving transistor, for a sensing period.

In addition, the fourth thin film transistor TR4 transfers the driving voltage Vdd to the second thin film transistor TR2 in accordance with the emission control signal EM, or shields the driving voltage Vdd. When the fourth thin film transistor TR4 is turned on, a current is supplied to the second thin film transistor TR2, whereby light is output from the display device 710. The pixel driving circuit PDC according to further still another example of the present disclosure can be formed in various structures in addition to the above-described structure. The pixel driving circuit PDC may include, for example, five or more thin film transistors.

According to the present disclosure, the following advantages are obtained.

The thin film transistor according to one example of the present disclosure has a large s-factor and at the same time has excellent ON-current characteristics. Therefore, when the thin film transistor is used in the display apparatus, a gray scale representation capability of the display apparatus can be improved, and current characteristics of the display apparatus can be also improved.

**Claims**

1.  A thin film transistor (100) comprising:

    an active layer (130); and
    a gate electrode (150) at least partially overlapped with the active layer,
    wherein the active layer (130) includes:

        a first active layer (131) and a second active layer (132) on the first active layer;
        a channel (130n);
        a first connection portion (130a) contacting a first side of the channel; and
        a second connection portion (130b) contacting a second side of the channel,

    wherein the channel includes:

        a first overlap area (OA1) in which the first active layer and the second active layer overlap each other based on a plan view; and
        a first non-overlap area (NOA1) in which the first active layer (131) and the second active layer (132) do not overlap each other based on the plan view,

    wherein in the channel of the active layer, each of the first active layer and the second active layer extends from the first connection portion (130a) to the second connection portion (130b), and
    wherein the second active layer (132) has a mobility greater than a mobility of the first active layer (131);
    wherein the active layer (130) further includes a third active layer (133) on the second active layer (132),
    wherein the third active layer (133) extends from the first connection portion (130a) to the second connection portion (130b) in the channel, and
    wherein the third active layer (133) has a mobility smaller than a mobility of the second active layer (132).

2.  The thin film transistor of claim 1, wherein the first overlap area of the channel extends from the first connection portion to the second connection portion.

3.  The thin film transistor of claim 1 or claim 2, wherein the first non-overlap area of the channel extends from the first connection portion to the second connection portion.

4.  The thin film transistor of any one of the preceding claims, wherein the second active layer covers an upper surface of the first active layer in the channel; or optionally wherein the second active layer is disposed in an area of the channel based on the plan view.

5.  The thin film transistor of any one of the preceding claims, wherein the first active layer is not disposed in the first non-overlap area of the channel.

6.  The thin film transistor of claim 5, wherein the third active layer is disposed in the first overlap area and the first non-overlap area of the channel; or optionally wherein the third active layer is not disposed in the first non-overlap area of the channel.

7.  The thin film transistor of any one of the preceding claims, wherein the channel further includes a second non-overlap area in which the first active layer and the second active layer do not overlap each other based on the plan view, and wherein the second non-overlap area is spaced apart from the first non-overlap area and extends from the first connection portion to the second connection portion.

8.  The thin film transistor of claim 7, wherein the first active layer is not disposed in the second non-overlap area of the channel.

9. The thin film transistor of claim 7, wherein the active layer further includes a third active layer on the second active layer,

wherein the third active layer extends from the first connection portion to the second connection portion in the channel, and
wherein the third active layer has a mobility smaller than a mobility of the second active layer.

10. The thin film transistor of claim 9, wherein the third active layer is disposed in the first overlap area, the first non-overlap area and the second non-overlap area of the channel; or optionally wherein the third active layer is not disposed in the second non-overlap area of the channel.

11. The thin film transistor of claim 1, wherein the channel further includes a second overlap area in which the first active layer and the second active layer overlap each other based on the plan view, and wherein the second overlap area is spaced apart from the first overlap area, and extends from the first connection portion to the second connection portion.

12. The thin film transistor of claim 11, wherein the active layer further includes a third active layer on the second active layer,

wherein the third active layer extends from the first connection portion to the second connection portion in the channel, and
wherein the third active layer has a mobility smaller than a mobility of the second active layer; and optionally

wherein the third active layer is disposed in the first overlap area, the first non-overlap area and the second overlap area of the channel; or optionally
wherein the third active layer is not disposed in the first non-overlap area of the channel.

13. The thin film transistor of any one of the preceding claims, wherein the first active layer includes at least one of an IGZO (InGaZnO)-based oxide semiconductor material, a GZO (GaZnO)-based oxide semiconductor material, an IGO (InGaO)-based oxide semiconductor material, or a GZTO (GaZnSnO)-based oxide semiconductor material, and when the oxide semiconductor material of the first active layer includes gallium (Ga) and indium (In), a concentration of gallium (Ga) is higher than a concentration of indium (In) based on the number of moles [Ga concentration > In concentration]; or optionally

wherein the second active layer includes at least one of an IGZO (InGaZnO)-based oxide semiconductor material, an IZO (InZnO)-based oxide semiconductor material, an ITZO (InSnZnO)-based oxide semiconductor material, an IGZTO (InGaZnSnO)-based oxide semiconductor material, a FIZO (FeInZnO)-based semiconductor material, a ZnO-based oxide semiconductor material, a SIZO (SiInZnO)-based oxide semiconductor material, or a ZnON (Zn-Oxynitride)-based oxide semiconductor material, and when the oxide semiconductor material of the second active layer includes gallium (Ga) and indium (In), a concentration of indium (In) is higher than a concentration of gallium (Ga) based on the number of moles [Ga concentration < In concentration].

14. A display apparatus comprising the thin film transistor (100) of any one of the preceding claims.

**Patentansprüche**

1. Dünnschichttransistor (100), umfassend:

eine aktive Schicht (130); und
eine Gate-Elektrode (150), die zumindest teilweise mit der aktiven Schicht überlappt, wobei die aktive Schicht (130) einschließt:

eine erste aktive Schicht (131) und eine zweite aktive Schicht (132) auf der ersten aktiven Schicht;
einen Kanal (130n);
einen ersten Verbindungsabschnitt (130a), der eine erste Seite des Kanals kontaktiert; und
einen zweiten Verbindungsabschnitt (130b), der eine zweite Seite des Kanals kontaktiert, wobei der Kanal einschließt:

einen ersten Überlappungsbereich (OA1), in dem sich die erste aktive Schicht und die zweite aktive Schicht überlappen, basierend auf einer Draufsicht; und
einen ersten Nichtüberlappungsbereich (NOA1), in dem die erste aktive Schicht (131) und die zweite aktive Schicht (132) sich nicht überlappen, basierend auf der Draufsicht,
wobei sich in dem Kanal der aktiven Schicht jede von der ersten aktiven Schicht und der zweiten aktiven Schicht von dem ersten Verbindungsabschnitt (130a) zu dem zweiten Verbindungsabschnitt (130b) erstreckt, und
wobei die zweite aktive Schicht (132) eine Mobilität aufweist, die größer als eine Mobilität der ersten aktiven Schicht (131) ist;

wobei die aktive Schicht (130) ferner eine dritte aktive Schicht (133) auf der zweiten aktiven Schicht (132) einschließt,

wobei sich die dritte aktive Schicht (133) von dem ersten Verbindungsabschnitt (130a) zu dem zweiten Verbindungsabschnitt (130b) in dem Kanal erstreckt, und wobei die dritte aktive Schicht (133) eine Mobilität aufweist, die kleiner als eine Mobilität der zweiten aktiven Schicht (132) ist.

2. Dünnschichttransistor nach Anspruch 1, wobei sich der erste Überlappungsbereich des Kanals von dem ersten Verbindungsabschnitt zu dem zweiten Verbindungsabschnitt erstreckt.

3. Dünnschichttransistor nach Anspruch 1 oder Anspruch 2, wobei sich der erste Nichtüberlappungsbereich des Kanals von dem ersten Verbindungsabschnitt zu dem zweiten Verbindungsabschnitt erstreckt.

4. Dünnschichttransistor nach einem der vorhergehenden Ansprüche, wobei die zweite aktive Schicht eine obere Oberfläche der ersten aktiven Schicht in dem Kanal bedeckt; oder wobei gegebenenfalls die zweite aktive Schicht in einem Bereich des Kanals angeordnet ist, basierend auf der Draufsicht.

5. Dünnschichttransistor nach einem der vorhergehenden Ansprüche, wobei die erste aktive Schicht nicht in dem ersten Nichtüberlappungsbereich des Kanals angeordnet ist.

6. Dünnschichttransistor nach Anspruch 5, wobei die dritte aktive Schicht in dem ersten Überlappungsbereich und dem ersten Nichtüberlappungsbereich des Kanals angeordnet ist; oder wobei gegebenenfalls die dritte aktive Schicht nicht in dem ersten Nichtüberlappungsbereich des Kanals angeordnet ist.

7. Dünnschichttransistor nach einem der vorhergehenden Ansprüche, wobei der Kanal ferner einen zweiten Nichtüberlappungsbereich einschließt, in dem die erste aktive Schicht und die zweite aktive Schicht einander nicht überlappen, basierend auf der Draufsicht, und wobei der zweite Nichtüberlappungsbereich von dem ersten Nichtüberlappungsbereich beabstandet ist und sich von dem ersten Verbindungsabschnitt zu dem zweiten Verbindungsabschnitt erstreckt.

8. Dünnschichttransistor nach Anspruch 7, wobei die erste aktive Schicht nicht in dem zweiten Nichtüberlappungsbereich des Kanals angeordnet ist.

9. Dünnschichttransistor nach Anspruch 7, wobei die aktive Schicht ferner eine dritte aktive Schicht auf der zweiten aktiven Schicht einschließt,

wobei sich die dritte aktive Schicht von dem ersten Verbindungsabschnitt zu dem zweiten Verbindungsabschnitt in dem Kanal erstreckt, und wobei die dritte aktive Schicht eine Mobilität aufweist, die kleiner als eine Mobilität der zweiten aktiven Schicht ist.

10. Dünnschichttransistor nach Anspruch 9, wobei die dritte aktive Schicht in dem ersten Überlappungsbereich, dem ersten Nichtüberlappungsbereich und dem zweiten Nichtüberlappungsbereich des Kanals angeordnet ist; oder wobei gegebenenfalls die dritte aktive Schicht nicht in dem zweiten Nichtüberlappungsbereich des Kanals angeordnet ist.

11. Dünnschichttransistor nach Anspruch 1, wobei der Kanal ferner einen zweiten Überlappungsbereich einschließt, in dem die erste aktive Schicht und die zweite aktive Schicht einander überlappen, basierend auf der Draufsicht, und wobei der zweite Überlappungsbereich von dem ersten Überlappungsbereich beabstandet ist und sich von dem ersten Verbindungsabschnitt zu dem zweiten Verbindungsabschnitt erstreckt.

12. Dünnschichttransistor nach Anspruch 11, wobei die aktive Schicht ferner eine dritte aktive Schicht auf der zweiten aktiven Schicht einschließt,

wobei sich die dritte aktive Schicht von dem ersten Verbindungsabschnitt zu dem zweiten Verbindungsabschnitt in dem Kanal erstreckt, und wobei die dritte aktive Schicht eine Mobilität aufweist, die kleiner als eine Mobilität der zweiten aktiven Schicht ist; und wobei gegebenenfalls die dritte aktive Schicht in dem ersten Überlappungsbereich, dem ersten Nichtüberlappungsbereich und dem zweiten Überlappungsbereich des Kanals angeordnet ist; oder wobei gegebenenfalls die dritte aktive Schicht nicht in dem ersten Nichtüberlappungsbereich des Kanals angeordnet ist.

13. Dünnschichttransistor nach einem der vorhergehenden Ansprüche, wobei die erste aktive Schicht zumindest eines von einem Oxidhalbleitermaterial auf IGZO(InGaZnO)-Basis, einem Oxidhalbleitermaterial auf GZO(GaZnO)-Basis, einem Oxidhalbleitermaterial auf IGO(InGaO)-Basis oder einem Oxidhalbleitermaterial auf GZTO(GaZnSnO)-Basis einschließt, und wenn das Oxidhalbleitermaterial der ersten aktiven Schicht Gallium (Ga) und Indium (In) einschließt, eine Konzentration von Gallium (Ga) höher als eine Konzentration von Indium (In) ist, basierend auf der Anzahl der Mole [Ga-Konzentration > In-Konzentration]; oder wobei gegebenenfalls die zweite aktive Schicht zumindest eines von einem Oxidhalbleitermaterial auf IGZO(InGaZnO)-Basis, einem Oxidhalbleitermaterial auf IZO(InZnO)-Basis, einem Oxidhalbleitermaterial auf ITZO(InSnZnO)-Basis, einem Oxidhalbleitermaterial auf IGZTO(InGaZnSnO)-Basis, einem Halbleitermaterial auf FIZO(FeInZnO)-Basis, einem Oxidhalbleitermaterial auf ZnO-Basis, einem Oxidhalbleitermaterial auf SIZO(SiInZnO)-Basis oder einem Oxidhalbleitermaterial auf ZnON(Zn-Oxynitrid)-Basis einschließt, und wenn das Oxidhalbleitermaterial der zweiten aktiven Schicht Gallium (Ga) und Indium (In) einschließt, eine Konzentration von Indium (In) höher als eine Konzentration von Gallium (Ga) ist, basierend auf der Anzahl von Molen [Ga-Konzentration < In-Konzentration].

14. Anzeigeeinrichtung, die den Dünnschichttransistor (100) nach einem der vorhergehenden Ansprüche umfasst.

## Revendications

1. Transistor en couches minces (100) comprenant :

   une couche active (130) ; et
   une électrode de grille (150) en chevauchement au moins partiel avec la couche active, la couche active (130) comportant :

      une première couche active (131) et une deuxième couche active (132) sur la première couche active ;
      un canal (130n) ;
      une première partie de connexion (130a) en contact avec un premier côté du canal ; et
      une deuxième partie de connexion (130b) en contact avec un deuxième côté du canal, le canal comportant :

         une première zone de chevauchement (OA1) dans laquelle la première couche active et la deuxième couche active se chevauchent d'après une vue en plan ; et
         une première zone sans chevauchement (NOA1) dans laquelle la première couche active (131) et la deuxième couche active (132) ne se chevauchent pas d'après la vue en plan,
   dans lequel, dans le canal de la couche active, la première couche active et la deuxième couche active s'étendent chacune de la première partie de connexion (130a) à la deuxième partie de connexion (130b), et
   dans lequel la deuxième couche active (132) présente une mobilité supérieure à une mobilité de la première couche active (131) ;
   dans lequel la couche active (130) comporte en outre une troisième couche active (133) sur la deuxième couche active (132),
   dans lequel la troisième couche active (133) s'étend de la première partie de connexion (130a) à la deuxième partie de connexion (130b) dans le canal, et
   dans lequel la troisième couche active (133) présente une mobilité inférieure à une mobilité de la deuxième couche active (132).

2. Transistor en couches minces selon la revendication 1, dans lequel la première zone de chevauchement du canal s'étend de la première partie de connexion à la deuxième partie de connexion.

3. Transistor en couches minces selon la revendication 1 ou la revendication 2, dans lequel la première zone sans chevauchement du canal s'étend de la première partie de connexion à la deuxième partie de connexion.

4. Transistor en couches minces selon l'une quelconque des revendications précédentes, dans lequel la deuxième couche active recouvre une surface supérieure de la première couche active dans le canal ; ou éventuellement dans lequel la deuxième couche active est disposée dans une zone du canal d'après la vue en plan.

5. Transistor en couches minces selon l'une quelconque des revendications précédentes, dans lequel la première couche active n'est pas disposée dans la première zone sans chevauchement du canal.

6. Transistor en couches minces selon la revendication 5, dans lequel la troisième couche active est disposée dans la première zone de chevauchement et la première zone sans chevauchement du canal ; ou éventuellement dans lequel la troisième couche active n'est pas disposée dans la première zone sans chevauchement du canal.

**7.** Transistor en couches minces selon l'une quelconque des revendications précédentes, dans lequel le canal comporte en outre une deuxième zone sans chevauchement dans laquelle la première couche active et la deuxième couche active ne se chevauchent pas d'après la vue en plan, et dans lequel la deuxième zone sans chevauchement est espacée de la première zone sans chevauchement et s'étend de la première partie de connexion à la deuxième partie de connexion.

**8.** Transistor en couches minces selon la revendication 7, dans lequel la première couche active n'est pas disposée dans la deuxième zone sans chevauchement du canal.

**9.** Transistor en couches minces selon la revendication 7, dans lequel la couche active comporte en outre une troisième couche active sur la deuxième couche active, dans lequel la troisième couche active s'étend de la première partie de connexion à la deuxième partie de connexion dans le canal, et dans lequel la troisième couche active présente une mobilité inférieure à une mobilité de la deuxième couche active.

**10.** Transistor en couches minces selon la revendication 9, dans lequel la troisième couche active est disposée dans la première zone de chevauchement, la première zone sans chevauchement et la deuxième zone sans chevauchement du canal ; ou éventuellement dans lequel la troisième couche active n'est pas disposée dans la deuxième zone sans chevauchement du canal.

**11.** Transistor en couches minces selon la revendication 1, dans lequel le canal comporte en outre une deuxième zone de chevauchement dans laquelle la première couche active et la deuxième couche active se chevauchent d'après la vue en plan, et dans lequel la deuxième zone de chevauchement est espacée de la première zone de chevauchement, et s'étend de la première partie de connexion à la deuxième partie de connexion.

**12.** Transistor en couches minces selon la revendication 11, dans lequel la couche active comporte en outre une troisième couche active sur la deuxième couche active, dans lequel la troisième couche active s'étend de la première partie de connexion à la deuxième partie de connexion dans le canal, et

dans lequel la troisième couche active présente une mobilité inférieure à une mobilité de la deuxième couche active ; et éventuellement dans lequel la troisième couche active est disposée dans la première zone de chevauchement, la première zone sans chevauchement et la deuxième zone de chevauchement du canal ; ou éventuellement dans lequel la troisième couche active n'est pas disposée dans la première zone sans chevauchement du canal.

**13.** Transistor en couches minces selon l'une quelconque des revendications précédentes, dans lequel la première couche active comporte au moins un matériau parmi un matériau semi-conducteur en oxyde à base d'IGZO (InGaZnO), un matériau semi-conducteur en oxyde à base de GZO (GaZnO), un matériau semi-conducteur en oxyde à base d'IGO (InGaO), et un matériau semi-conducteur en oxyde à base de GZTO (GaZnSnO), et quand le matériau semi-conducteur en oxyde de la première couche active comporte du gallium (Ga) et de l'indium (In), une concentration de gallium (Ga) est supérieure à une concentration d'indium (In) sur la base du nombre de moles [concentration de Ga > concentration d'In] ; ou éventuellement dans lequel la deuxième couche active comporte au moins un matériau parmi un matériau semi-conducteur en oxyde à base d'IGZO (InGaZnO), un matériau semi-conducteur en oxyde à base d'IZO (InZnO), un matériau semi-conducteur en oxyde à base d'ITZO (InSnZnO), un matériau semi-conducteur en oxyde à base d'IGZTO (InGaZnSnO), un matériau semi-conducteur en oxyde à base de FIZO (FeInZnO), un matériau semi-conducteur en oxyde à base de ZnO, un matériau semi-conducteur en oxyde à base de SIZO (SiInZnO), et un matériau semi-conducteur en oxyde à base de ZnON (oxynitrure de Zn), et quand le matériau semi-conducteur en oxyde de la deuxième couche active comporte du gallium (Ga) et de l'indium (In), une concentration d'indium (In) est supérieure à une concentration de gallium (Ga) sur la base du nombre de moles [concentration de Ga < concentration d'In].

**14.** Appareil d'affichage comprenant le transistor en couches minces (100) de l'une quelconque des revendications précédentes.

# FIG. 1A

100

II  III

161

H1

H2

111

130a

150

130n

I ——————————— I'

OA1

NOA1

130 { 131
132

130b

162

H3

II'  III'

# FIG. 1B

100

130
131  132  150

170

140

120

110

I                                    I'

111

OA1        NOA1

130n

# FIG. 1C

100

H1  161  H2        150        H3  162

170

132 } 130
131 }
140

120

110

II                                    II'

111  131a 132a  131n 132n  131b 132b

130a    130n    130b

130

# FIG. 1D

100

H1   161   H2          150          H3   162

III                                                    III'

170

132
140
120
110

111

132a      132n      132b

132

# FIG. 2

200

161   H2        150   140        H3   162

II                                                      II'

170

132 } 130
131 }

120
110

131a  132a    131n  132n    131b  132b

130a      130n      130b

130

# FIG. 3A

300

H1

161

H2

111

150

130a

130n

Ia — Ia'

OA1

NOA1

131
132
130
133

130b

H3

162

# FIG. 3B

300

130
131  132  133  150

170

140

120

110

Ia                                    Ia'

OA1      NOA1      111

130n

# FIG. 4A

400

H1

H2

161

111 — 130a

150 — 130n

Ib ——————— Ib'

OA1

NOA1

131
132    130
133

130b

H3

162

# FIG. 4B

400

130
131  132  133  150

170

140

120

110

Ib  Ib'

OA1  NOA1  111

130n

# FIG. 5A

500

H1

161

H2

111

130a

150

130n

OA1

IV IV'

NOA1

NOA2

130 { 131
132

130b

162

H3

# FIG. 5B

500

130
131  132  150

170

140

120

110

IV                                      IV'

111

NOA2    OA1    NOA2

130n

# FIG. 6

600

130
131  132  133  150

170

140

120

110

IV                                      IV'

111

NOA2    OA1    NOA2

130n

# FIG. 7A

700

# FIG. 7B

700

130
131 132 133    150

170

140

120

110

IVa                                    IVa'

111

NOA2    OA1    NOA2

130n

# FIG. 8A

800

# FIG. 8B

800

130

131  132  131          150

170

140

120

110

V                        V'

111

OA2   NOA1   OA1

130n

# FIG. 9A

900

H1

161

H2

111

130a

150

130n

NOA1

Va —— —— Va'

OA1

OA2

131
130 { 132
133

130b

131

H3

162

# FIG. 9B

900

130

131  132  133  131          150

170

140

120

110

Va                                         Va'

111

OA2    NOA1    OA1

130n

# FIG. 10A

1000

H1

161

H2

111 · 130a

150 · 130n

NOA1

Vb — Vb'

OA1

OA2

130 { 131
132
133

130b

131
132 } 130
133

162

H3

# FIG. 10B

1000

130

131  132  133  133  131        150

170

140

120

110

Vb                                              Vb'

OA2    NOA1    OA1        111

130n

# FIG. 11A

# FIG. 11B

# FIG. 12A

150(Gate)

140(GI) $C_{GI}$

130n(CH) $C_{CH}$ 130a(Source)

121 $C_{BUF}$

111

# FIG. 12B

$V_{GS}$

$C_{GI}$

$V_{eff}$

$C_{CH}$ $C_{BUF}$

111/Source

# FIG. 13A

# FIG. 13B

# FIG. 14

# FIG. 15

# FIG. 16

## FIG. 17

# FIG. 18

# FIG. 19

**REFERENCES CITED IN THE DESCRIPTION**

**Patent documents cited in the description**

- KR 20230067042 A

- CN 114628528 A